(19) Europäisches Patentamt / European Patent Office / Office européen des brevets

(11) **EP 2 648 009 A1**

(12) **EUROPEAN PATENT APPLICATION**
published in accordance with Art. 153(4) EPC

(43) Date of publication:
**09.10.2013 Bulletin 2013/41**

(51) Int Cl.:
*G01R 31/02* (2006.01)     *G01R 31/26* (2006.01)
*H01L 31/04* (2006.01)

(21) Application number: **11845536.9**

(22) Date of filing: **25.11.2011**

(86) International application number:
**PCT/JP2011/077250**

(87) International publication number:
**WO 2012/073836 (07.06.2012 Gazette 2012/23)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.11.2010   JP 2010265397**

(71) Applicant: **JX Nippon Oil & Energy Corporation
Chiyoda-ku
Tokyo 100-8162 (JP)**

(72) Inventors:
• **YOSHIDOMI, Masanobu
  Nagoya-shi, Aichi 4650092 (JP)**
• **ISHII, Takafumi
  Tokyo 100-8162 (JP)**

(74) Representative: **Grünecker, Kinkeldey,
Stockmair & Schwanhäusser
Leopoldstrasse 4
80802 München (DE)**

(54) **GROUND FAULT DETECTION DEVICE, GROUND FAULT DETECTION METHOD, SOLAR ENERGY GENERATOR SYSTEM, AND GROUND FAULT DETECTION PROGRAM**

(57)     A ground fault detection device detects a ground fault within a photovoltaic array in a solar energy generator system including a photovoltaic string composed of a plurality of photovoltaic modules connected in series, the photovoltaic array composed of a plurality of the photovoltaic strings connected in parallel, and a load device consuming or converting electric power. The ground fault detection device includes a switching section which parallels off the photovoltaic array or the photovoltaic string by electrically disconnecting the photovoltaic array or the photovoltaic string from the solar energy generator system and a detection section which detects a ground fault in the photovoltaic array or the photovoltaic string while the photovoltaic array or the photovoltaic string is paralleled off by the switching section.

Fig.1

## Description

### Technical Field

The present invention relates to a ground fault detection device, a ground fault detection method, a solar energy generator system, and a ground fault detection program.

### Background Art

In a general solar energy generator system for generating electric power using sunlight, a plurality of photovoltaic modules are connected in series to constitute a photovoltaic string, and a plurality of photovoltaic strings are connected in parallel to constitute a photovoltaic array. An output from the photovoltaic array is supplied to a load device such as a power conditioner and then supplied to a commercial electric power system or the like.

If there is defective insulation within a photovoltaic array in such a solar energy generator system, a ground fault that is an unintentional contact of an electric circuit with the outside may occur, for example, when a human or an object touches a defectively insulated spot or when a defectively insulated spot and a metal stand or the like come into contact. As a product for detecting a ground fault, for example, the ground fault detection device disclosed in Patent Literature 1 has been known. The ground fault detection device disclosed in Patent Literature 1 measures a value of a current which flows from a grounded electric circuit of a photovoltaic array to the ground and, when the current value exceeds a set current value set in advance, detects a ground fault in the photovoltaic array.

### Citation List

### Patent Literature

Patent Literature 1: Japanese Patent Laid-Open No. 2003-158282

### Summary of Invention

### Technical Problem

The above-described ground fault detection device, however, may erroneously detect a ground fault due to an earth capacitance of a solar energy generator system . Especially if the photovoltaic array is constructed on a larger scale by, e.g., increasing the number of photovoltaic modules and the number of photovoltaic strings, since the capacitance of the earth capacitance increases due to the longer length of lead wire connecting the photovoltaic strings and the larger total area of the lead wire, the possibility of erroneous detection increases.

Additionally, the ground fault detection device is susceptible to noise arising from a load device (e.g., noise caused by high- frequency switching operation or commercial frequency (50 to 60 Hz) ) at the time of ground fault detection. This may also lead to erroneous detection of a ground fault.

Under the circumstances, the present invention has provides a ground fault detection device, a ground fault detection method, and a solar energy generator system capable of reliably detecting a ground fault.

### Solution to Problem

In order to solve the above-described problems, a ground fault detection device according to one aspect of the present invention is a ground fault detection device for detecting a ground fault within a photovoltaic array in a solar energy generator system including a photovoltaic string composed of a plurality of photovoltaic modules connected in series, the photovoltaic array composed of a plurality of the photovoltaic strings connected in parallel, and a load device consuming or converting electric power and includes a switching section which parallels off the photovoltaic array or the photovoltaic string by electrically disconnecting the photovoltaic array or the photovoltaic string from the solar energy generator system and a detection section which detects a ground fault in the photovoltaic array or the photovoltaic string while the photovoltaic array or the photovoltaic string is paralleled off by the switching section.

Since the photovoltaic array or the photovoltaic string, in which a ground fault is to be detected, is paralleled off from the solar energy generator system in the ground fault detection device, an earth capacitance of a ground fault detection target can be reduced. This can reduce adverse effects of the earth capacitance on ground fault detection. Additionally, the photovoltaic array or the photovoltaic string is electrically disconnected from the load device at the time of ground fault detection. This can inhibit ground fault detection from being adversely affected by noise arising from the load device. It is thus possible to reliably detect a ground fault.

The ground fault detection device may include a control section which controls operation of the switching section and the detection section, and after the control section causes a first photovoltaic string of the plurality of photovoltaic strings to be paralleled off from the solar energy generator system and be connected to the detection section and causes the detection section to perform ground fault detection of the first photovoltaic string, the control section may interpose a first waiting time between when the control section causes the first photovoltaic string to be paralleled off from the detection section and when the control section causes a second photovoltaic string of the plurality of photovoltaic strings to be paralleled off from the solar energy generator system and be connected to the detection section. With the provision of the first waiting time, for example, a phenomenon can be prevented in which the plurality of photovoltaic strings are connected in parallel to the detection section due to, e.g., a malfunction of the switching section to cause an unexpected current flow.

Alternatively, the detection section may have a second waiting time between when the detection section is connected to the paralleled- off photovoltaic array or the paralleled- off photovoltaic string and when the detection section starts detection of the ground fault. With the provision of the second waiting time, for example, electric charge accumulated in an earth capacitance can be discharged during the time, which allows inhibition of erroneous detection of a ground fault.

Alternatively, the detection section may include first and second sensing resistors which are connected to each other via a connection section and determine presence or absence of the ground fault on the basis of a detection value associated with a value of a current flowing from the connection section to a ground potential while an opposite side from the connection section of the first sensing resistor is connected to a positive side of the paralleled- off photovoltaic array or the paralleled- off photovoltaic string and an opposite side from the connection section of the second sensing resistor is connected to a negative side. In this case, ground fault detection can be performed on the photovoltaic array or the photovoltaic string in a paralleled- off state by monitoring the detection value associated with the current flowing from the connection section of the first and second sensing resistors to the ground potential. Note that, for example, the detection value corresponds to the value of the current in a case where the value of the current is directly monitored by a current sensor and corresponds to a value of a voltage generated in a resistor in a case where the resistor is interposed (the same applies to the detection values below) .

Alternatively, the detection section may include an AC power supply whose one side is connected to a ground potential and determine presence or absence of the ground fault on the basis of a detection value associated with, of a value of a current flowing from the AC power supply to the ground potential, a value of a current in phase with a value of an AC voltage from the AC power supply while the other side of the AC power supply is connected to the paralleled- off photovoltaic array or the paralleled- off photovoltaic string. In this case, ground fault detection can be performed on the photovoltaic array or the photovoltaic string in a paralleled- off state by monitoring, of the value of the current flowing from the AC power supply to the ground potential, the value of the current in phase with the value of the AC voltage from the AC power supply.

Alternatively, the detection section may include a DC power supply whose one side is connected to a ground potential and determine presence or absence of the ground fault on the basis of a detection value associated with a value of a current flowing from the DC power supply to the ground potential while the other side as a negative side or a positive side of the DC power supply is connected to a positive side or a negative side of the paralleled- off photovoltaic array or the paralleled- off photovoltaic string. In this case, ground fault detection can be performed on the photovoltaic array or the photovoltaic string in a paralleled- off state by monitoring the detection value associated with the value of the current flowing from the DC power supply to the ground potential.

Alternatively, the detection section may include at least one sensing resistor whose one side is connected to a ground potential, measure a value of a voltage drop across the sensing resistor as a first voltage drop value while the other side of the sensing resistor is connected to only a positive side of the paralleled- off photovoltaic array or the paralleled- off photovoltaic string, measure a value of a voltage drop across the sensing resistor as a second voltage drop value while the other side of the sensing resistor is connected to only a negative side of the paralleled- off photovoltaic array or the paralleled- off photovoltaic string, and determine presence or absence of the ground fault on the basis of the measured first and second voltage drop values. In a general case where ground fault detection is performed by monitoring for a zero- phase current, since a zero- phase current does not flow without a ground fault, advance sensing of defective insulation to the earth which causes a current to flow into a toucher or the like may be difficult. In this respect, the present invention measures the first and second voltage drop values and determines presence or absence of a ground fault on the basis of the first and second voltage drop values, instead of performing ground fault detection by monitoring for a zero- phase current, and can favorably sense defective insulation to the earth in advance.

Alternatively, the switching section may electrically connect the paralleled- off photovoltaic array or the paralleled- off photovoltaic string to the solar energy generator system if the ground fault is not detected by the detection section. In this case, the photovoltaic array or the photovoltaic string, in which the ground fault has not been detected, can be automatically connected to the solar energy generator system .

Alternatively, the switching section may keep the paralleled- off photovoltaic array or the paralleled- off photovoltaic string paralleled off from the solar energy generator system if the ground fault is detected by the detection section. In this case, the photovoltaic array or the photovoltaic string, in which the ground fault has been detected, can be kept paralleled off. It is thus possible to electrically disconnect a defectively insulated spot in the solar energy generator system and enhance the safety of the solar energy generator system.

Alternatively, the switching section may parallel off a plurality of the photovoltaic strings from the solar energy generator system, and the detection section may detect a ground fault in the plurality of photovoltaic strings while the plurality of photovoltaic strings are paralleled off by the switching section. In this case, the total number of ground fault detection operations at the time of ground fault detection within the photovoltaic array can be made smaller than in a case where the photovoltaic strings are paralleled off and subjected to ground fault detection one at a time.

A ground fault detection method according to one aspect of the present invention is a ground fault detection method for detecting a ground fault within a photovoltaic array in a solar energy generator system including a photovoltaic string composed of a plurality of photovoltaic modules connected in series, the photovoltaic array composed of a plurality of the photovoltaic strings connected in parallel, and a load device consuming or converting electric power and includes a parallel-off step of paralleling off the photovoltaic array or at least one of the photovoltaic strings from the solar energy generator system and a detection step of detecting a ground fault in the photovoltaic array or the photovoltaic string while the photovoltaic array or the photovoltaic string is paralleled off by the parallel-off step.

In the ground fault detection method as well, the photovoltaic array or the photovoltaic string, in which a ground fault is to be detected, is paralleled off from the solar energy generator system. The above-described advantageous working effect, i.e., the advantageous effect of reliably detecting a ground fault can thus be produced.

The ground fault detection method may include a first parallel-off step of paralleling off a first photovoltaic string of the plurality of photovoltaic strings from the solar energy generator system and connecting the first photovoltaic string to a detection section for ground fault detection, a first detection step of performing ground fault detection of the first photovoltaic string and paralleling off the first photovoltaic string from the detection section, after the first parallel-off step, a second parallel-off step of paralleling a second photovoltaic string of the plurality of photovoltaic strings from the solar energy generator system and connecting the second photovoltaic string to the detection section, after the first detection step, and an interposition step of interposing a first waiting time between when the first photovoltaic string is paralleled off from the detection section by the first detection step and when the second photovoltaic string is paralleled off from the solar energy generator system and is connected to the detection section by the second parallel-off step. With the provision of the first waiting time, for example, a phenomenon can be prevented in which the plurality of photovoltaic strings are connected in parallel to the detection section due to, e.g., a malfunction of the switching section to cause an unexpected current flow.

Alternatively, the detection step may have a second waiting time between when the detection section for ground fault detection is connected to the photovoltaic array or the photovoltaic string in a paralleled- off state and when the detection section starts detection of the ground fault. With the provision of the second waiting time, for example, electric charge accumulated in an earth capacitance can be discharged during the time, which allows inhibition of erroneous detection of a ground fault.

Alternatively, the ground fault detection method may further include a step of connecting electrically the paralleled- off photovoltaic array or the paralleled- off photovoltaic string to the solar energy generator system if the ground fault is not detected in the ground fault detection step. In this case, the photovoltaic array or the photovoltaic string, in which the ground fault has not been detected, can be automatically connected to the solar energy generator system.

Alternatively, the ground fault detection method may further include a step of keeping the paralleled- off photovoltaic array or the paralleled- off photovoltaic string paralleled off from the solar energy generator system if the ground fault is detected in the ground fault detection step. In this case, the photovoltaic array or the photovoltaic string, in which the ground fault has been detected, can be kept paralleled off It is thus possible to enhance the safety of the solar energy generator system .

Alternatively, the parallel- off step may include paralleling off a plurality of the photovoltaic strings from the solar energy generator system, and the detection step may include detecting a ground fault in the plurality of photovoltaic strings while the plurality of photovoltaic strings are paralleled off by the parallel- off step. In this case, the total number of ground fault detection operations at the time of ground fault detection within the photovoltaic array can be made smaller than in a case where the photovoltaic strings are paralleled off and subjected to ground fault detection one at a time.

A solar energy generator system according to one aspect of the present invention includes a photovoltaic string which is composed of a plurality of photovoltaic modules connected in series, a photovoltaic array which is composed of a plurality of the photovoltaic strings connected in parallel, a load device which consumes or converts electric power, and the above-described ground fault detection device.

In the solar energy generator system as well, since the solar energy generator system includes the above-described ground fault detection device, the photovoltaic array or the photovoltaic string, in which a ground fault is to be detected, is paralleled off from the solar energy generator system. The above-described working effect, i.e., the effect of reliably detecting a ground fault can thus be produced.

A ground fault detection program according to one aspect of the present invention is a ground fault detection program for detecting a ground fault within a photovoltaic array in a solar energy generator system including a photovoltaic string composed of a plurality of photovoltaic modules connected in series, the photovoltaic array composed of a plurality of the photovoltaic strings connected in parallel, and a load device consuming or converting electric power and causes a computer to execute a parallel-off function of paralleling off the photovoltaic array or the photovoltaic string by electrically disconnecting the photovoltaic array or the photovoltaic string from the solar energy generator system and a detection function of detecting a ground fault in the photovoltaic array or the photovoltaic string while the photovoltaic array or the photovoltaic string is paralleled off.

By the ground fault detection program as well, the photovoltaic array or the photovoltaic string, in which the ground fault is to be detected, is paralleled off from the solar energy generator system. The above-described working effect, i.e., the effect of reliably detecting a  ground fault can thus be produced.

**Advantageous Effects of Invention**

According to the present invention, it is possible to reliably detect a ground fault.

**Brief Description of Drawings**

[Figure 1] Figure 1 is a schematic configuration diagram showing a solar energy generator system including a ground fault detection device according to a first embodiment.

[Figure 2] Figure 2 is a schematic configuration diagram showing a switching section of the ground fault detection device according to the first embodiment.

[Figure 3] Figure 3 is a schematic configuration diagram showing a measurement section of the ground fault detection device according to the first embodiment.

[Figure 4] Figure 4 is a functional block diagram showing an arithmetic control section of the ground fault detection device according to the first embodiment.

[Figure 5] Figure 5 is a flow chart showing the operation of the ground fault detection device according to the first embodiment.

[Figure 6] Figure 6 is a schematic configuration diagram showing a measurement section of a ground fault detection device according to a second embodiment.

[Figure 7] Figure 7 is a flow chart showing the operation of the ground fault detection device according to the second embodiment.

[Figure 8] Figure 8 is a schematic configuration diagram showing a measurement section of a ground fault detection device according to a  modification of the second embodiment.

[Figure 9] Figure 9 is a schematic configuration diagram showing a measurement section of a ground fault detection device according to a different modification of the second embodiment.

[Figure 13] Figure 13 is a schematic configuration diagram showing a switching section of a ground fault detection device according to a third embodiment.

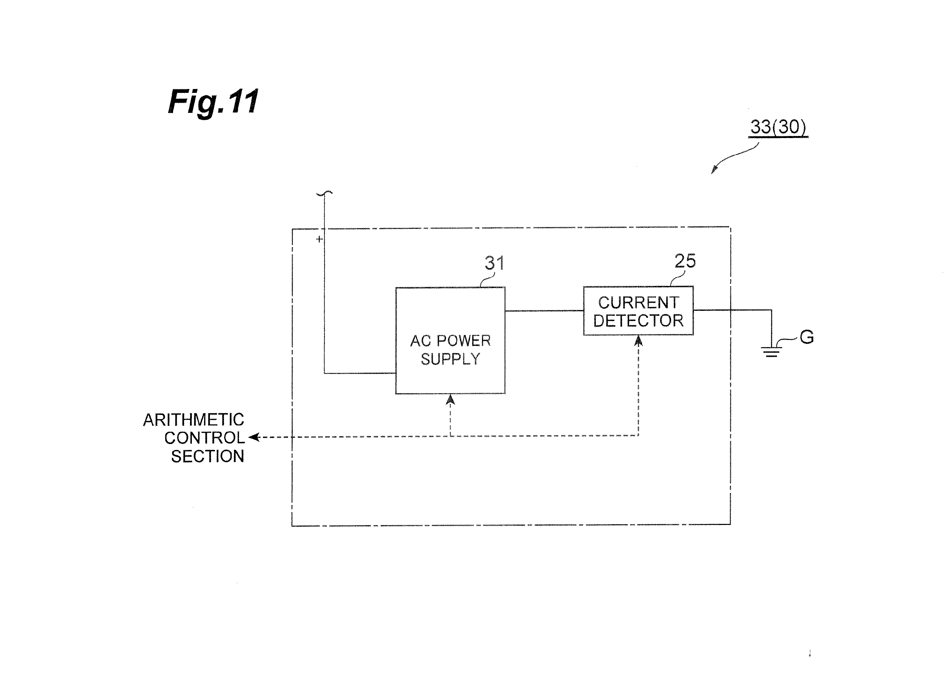

[Figure 11] Figure 11 is a schematic configuration diagram showing a measurement section of the ground fault detection device according to the third embodiment.

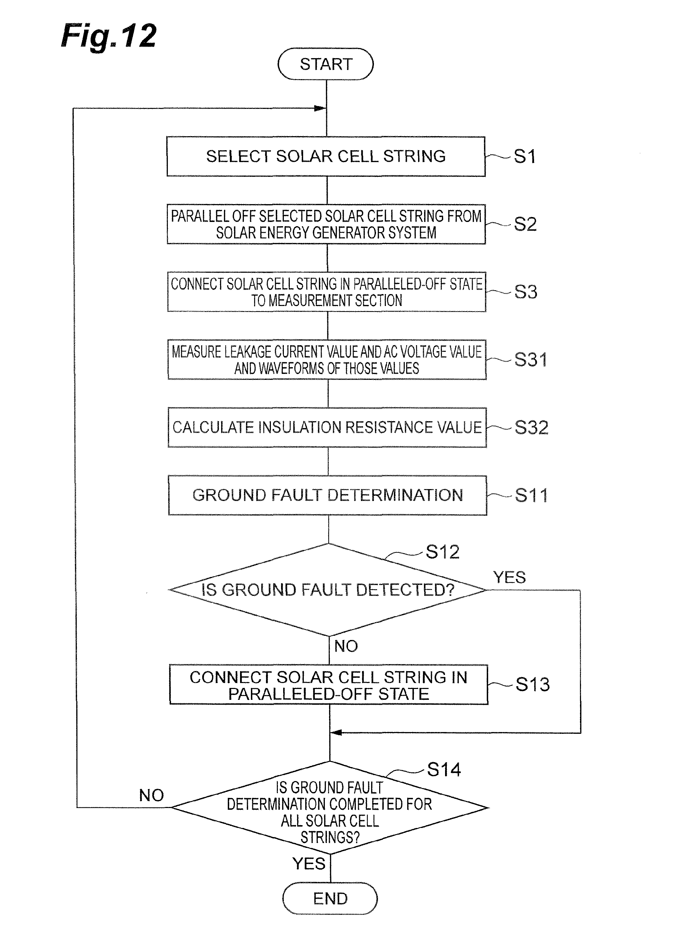

[Figure 12] Figure 12 is a flow chart showing the operation of the ground fault detection device according to the third embodiment.

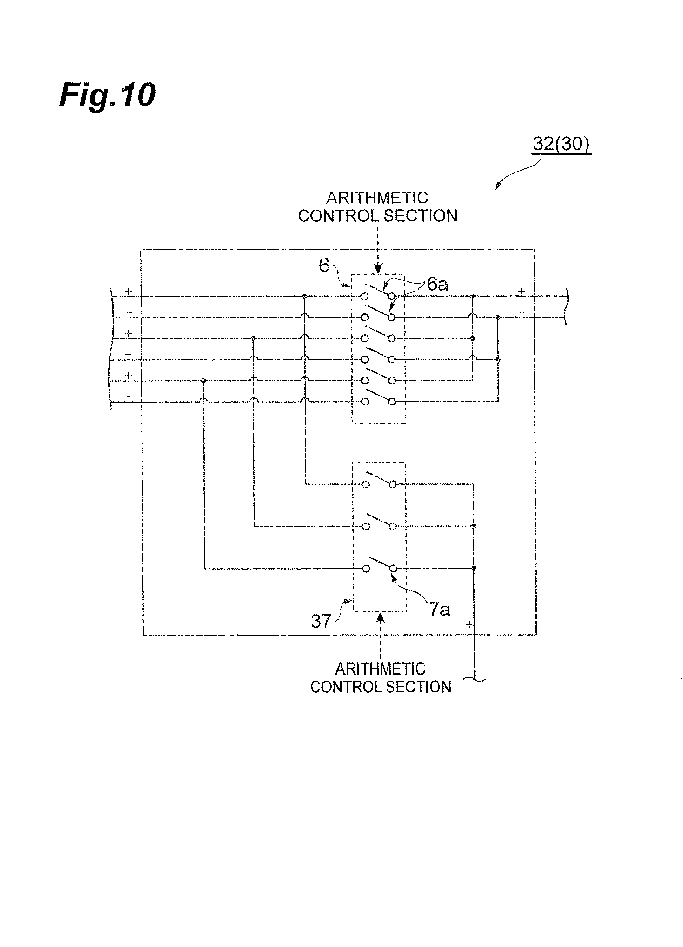

[Figure 10] Figure 10 is a schematic configuration diagram showing a measurement section in a ground fault detection device according to a modification of the third embodiment.

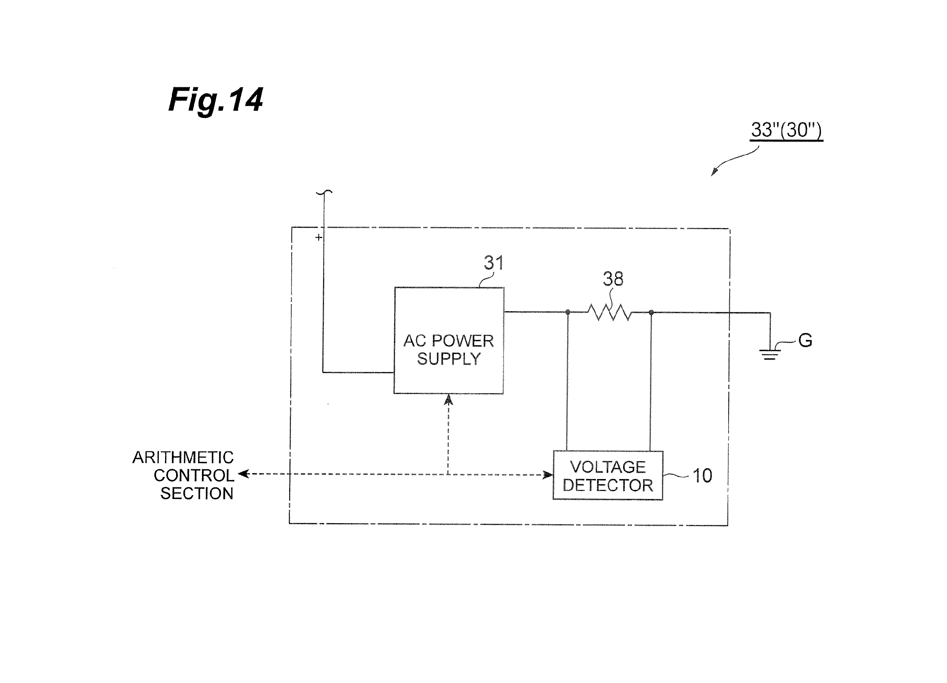

[Figure 14] Figure 14 is a schematic configuration diagram showing a measurement section in a ground fault detection device according to a different modification of the third embodiment.

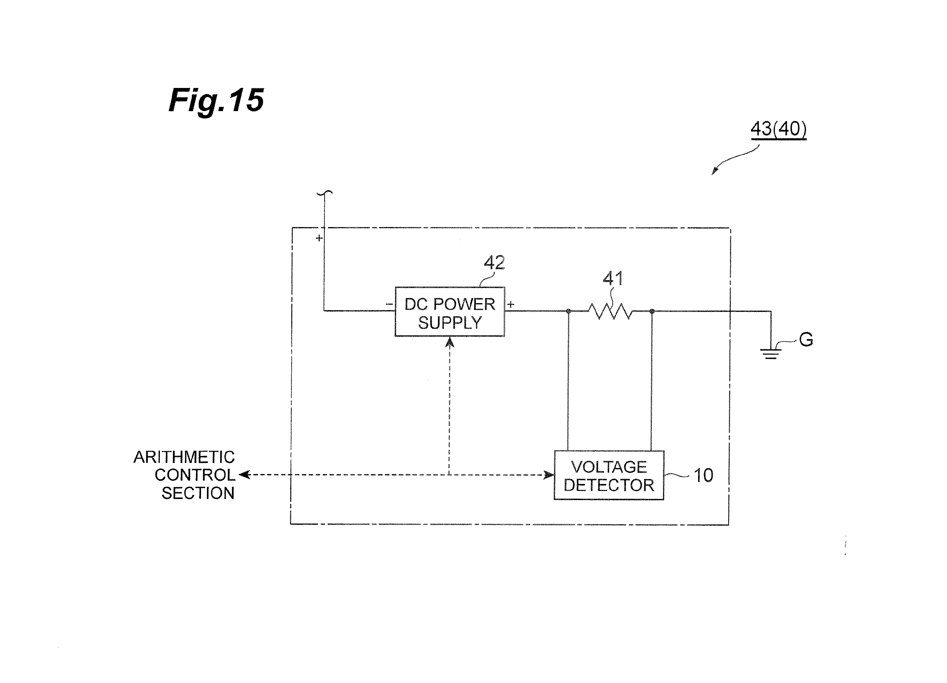

[Figure 15] Figure 15 is a schematic configuration diagram showing a measurement section of a ground fault detection device according to a fourth embodiment.

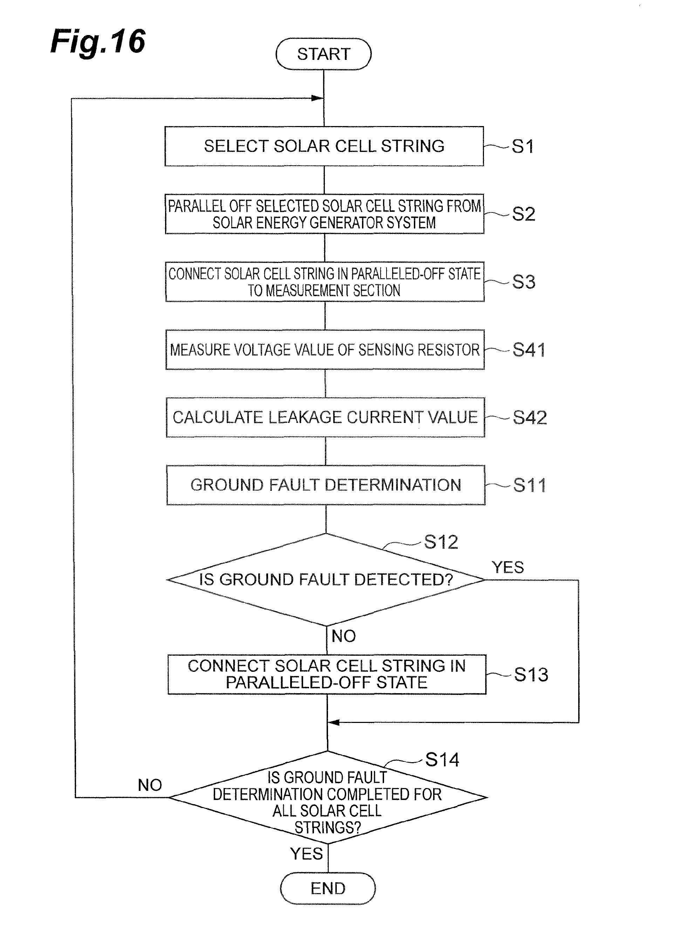

[Figure 16] Figure 16 is a flow chart showing the operation of the ground fault detection device according to the fourth embodiment.

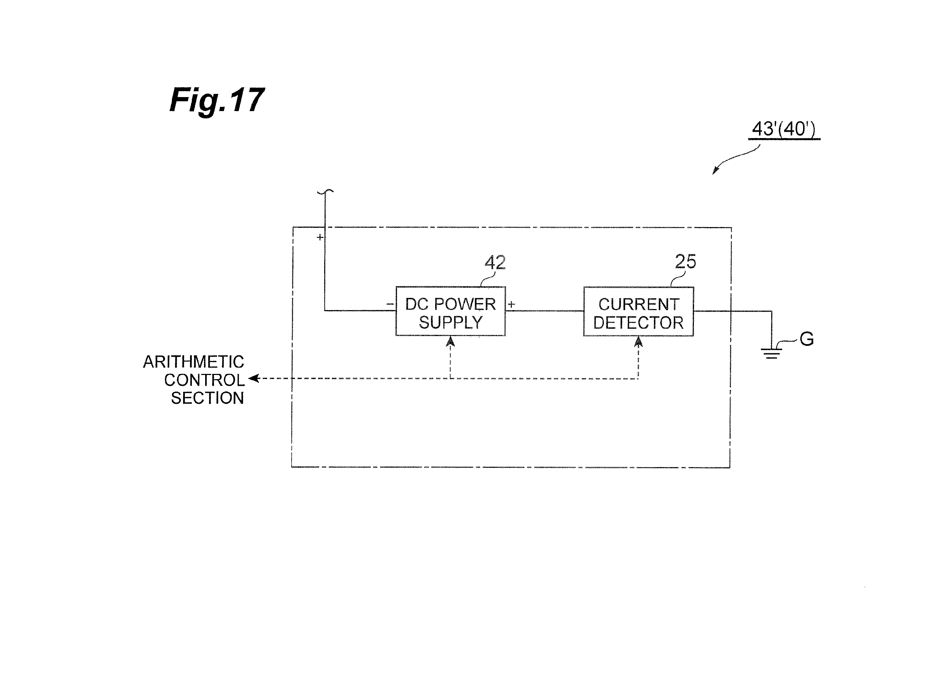

[Figure 17] Figure 17 is a schematic configuration diagram showing a measurement section in a ground fault detection device according to a modification of the fourth embodiment.

## Description of Embodiments

Preferred embodiments of the present invention will be described below with reference to the drawings. Note that, in the description below, same or corresponding components are denoted by same reference numerals and a redundant description will be omitted.

[First Embodiment]

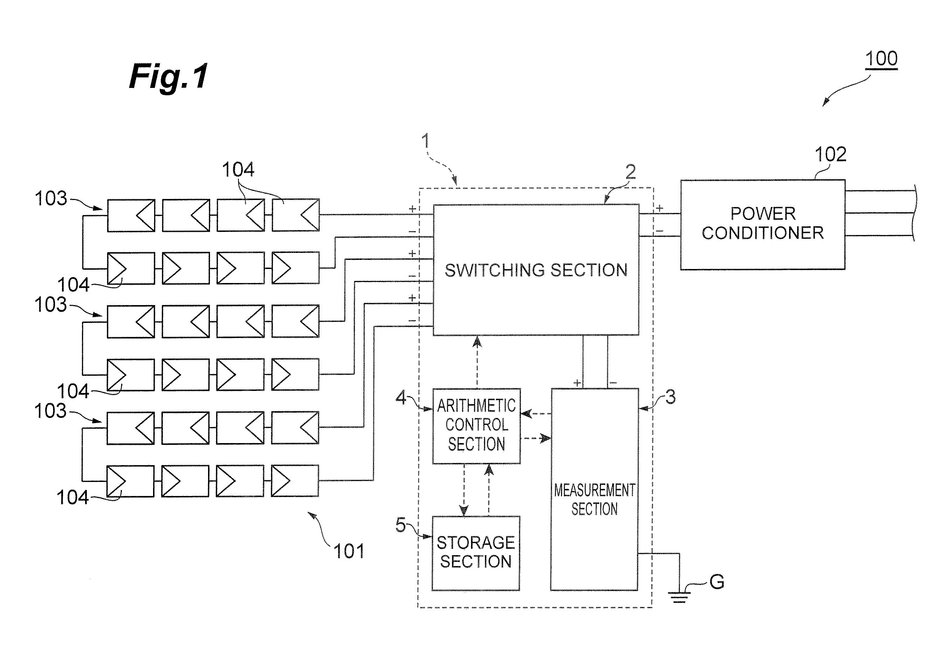

A first embodiment of the present invention will be described. Figure 1 is a schematic configuration diagram showing a solar energy generator system including a ground fault detection device according to a first embodiment. As shown in Figure 1, a ground fault detection device 1 according to the present embodiment is intended to detect a ground fault within a photovoltaic array 101 in a solar energy generator system 100. The solar energy generator system 100 will first be described.

The solar energy generator system 100 is a generator syste for generating electric power using solar energy and includes the photovoltaic array 101 and a power conditioner (load device) 102. The photovoltaic array 101 converts solar energy into electric energy and supplies the electric energy as a DC output to the power conditioner 102. The photovoltaic array 101 includes a plurality of (three here) photovoltaic strings 103 connected in parallel, and each of the plurality of photovoltaic strings 103 includes a plurality of (eight here) photovoltaic modules 104 connected in series. The plurality of photovoltaic strings 103 are connected to the power conditioner 102 via a switching section 2 of the ground fault detection device 1.

The power conditioner 102 converts a DC output supplied from the photovoltaic array 101 into an AC output and supplies the AC output to a downstream electric power system (e.g., a commercial electric power system). The power conditioner 102 includes an operating voltage control function of controlling the operating voltage of the photovoltaic array 101 so as to obtain maximum power of the photovoltaic array 101 and a system protection function of, e.g., safely stopping the system when an abnormality is detected in the electric power system. Note that the power conditioner 102 may be a transformer- isolated type one including an isolation transformer or a transformerless (non- isolated) type one.

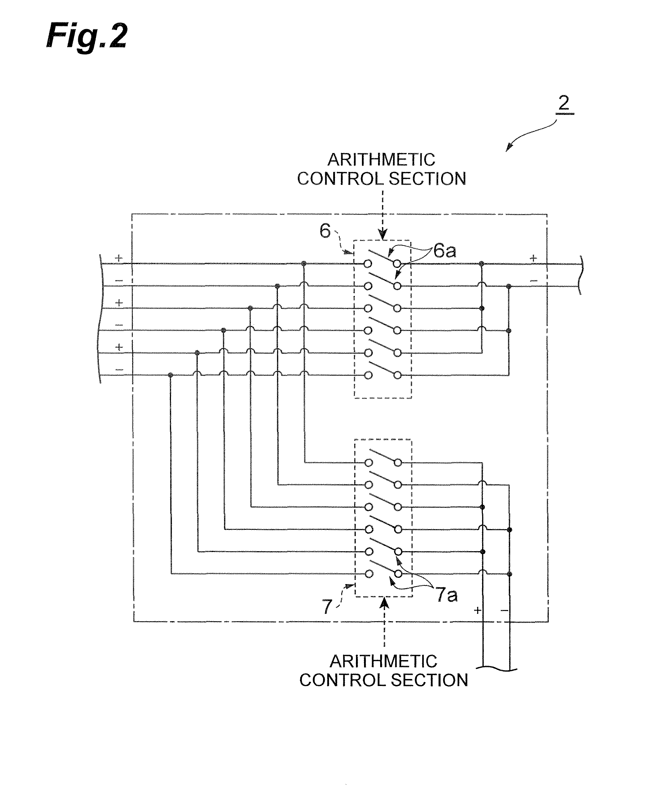

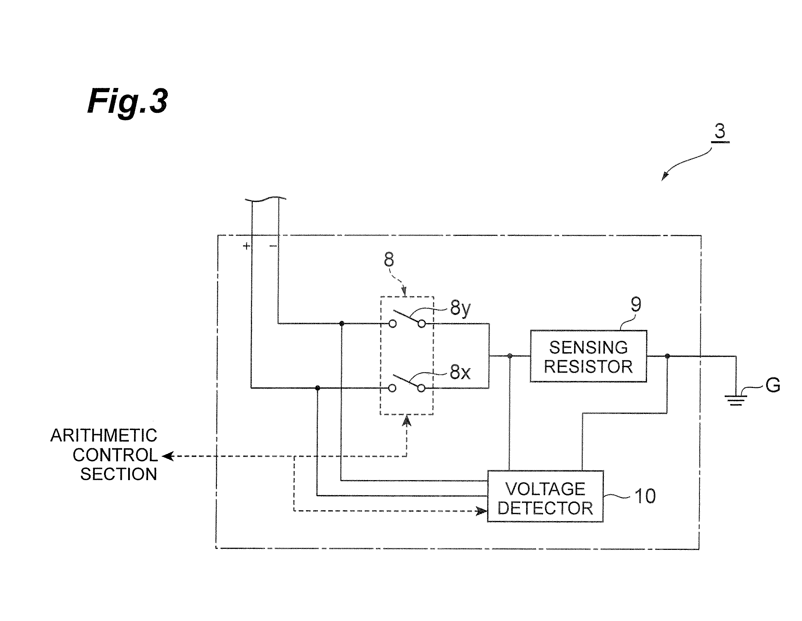

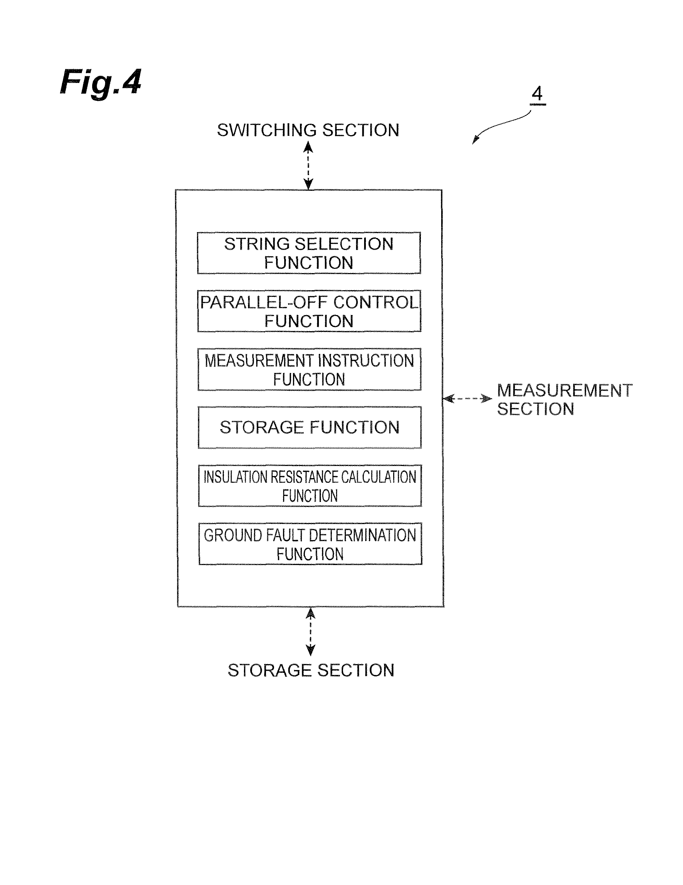

Figure 2 is a schematic configuration diagram showing the switching section of the ground fault detection device according to the first embodiment. Figure 3 is a schematic configuration diagram showing a measurement section of the ground fault detection device according to the first embodiment. Figure 4 is a functional block diagram showing an arithmetic control section of the ground fault detection device according to the first embodiment. As shown in Figures 1 to 3, the ground fault detection device 1 here performs ground fault detection for each of the plurality of photovoltaic strings 103. More specifically, the ground fault detection device 1 selects and parallels off the plurality of photovoltaic strings 103 one by one. The ground fault detection device 1 measures an insulation resistance value of each paralleled-off photovoltaic string 103, determines the presence or absence of a ground fault on the basis of the insulation resistance value, and, if there is no ground fault, reconnects the photovoltaic string 103 to the solar energy generator system 100. The ground fault detection device 1 includes the switching section 2, a measurement section 3, an arithmetic control section 4, and a storage section 5.

As shown in Figures 1 and 2, the switching section 2 is intended to parallel off the photovoltaic string 103 from the solar energy generator system 100 and connect the paralleled-off photovoltaic string 103 to the measurement section 3. The switching section 2 includes a switch 6 for parallel-off for paralleling off each photovoltaic string 103 from the solar energy generator system 100 and a switch 7 for measurement for connecting the paralleled-off photovoltaic string 103 to the measurement section 3. In the switching section 2, positive poles and negative poles of the photovoltaic strings 103 join into a positive bus and a negative bus, respectively, which are connected in parallel.

The switch 6 for parallel-off is located between the photovoltaic strings 103 and the power conditioner 102 to switch the photovoltaic strings 103 between electrically connected and electrically unconnected. The switch 6 for parallel-off includes a plurality of switching elements 6a for parallel-off which are connected in series with the positive poles and negative poles, respectively, of the photovoltaic strings 103. Each switching element 6a for parallel-off is connected to the arithmetic control section 4 and switches between on and off in accordance with an instruction signal from the arithmetic control section 4. The switching element 6a for parallel-off here is turned on and placed in an electrically connected state in normal times and is turned off and placed in an electrically cut-off state at the time of ground fault detection.

Of terminals on the power conditioner 102 side of the plurality of switching elements 6a for parallel-off, positive ones are connected together into a positive bus while negative ones are connected together into a negative bus. The positive bus and negative bus are connected to the power conditioner 102. As the switching element 6a for parallel-off, a semiconductor switch such as an FET (Field Effect Transistor) or a mechanical switch such as a relay switch can be used.

In the switch 6 for parallel-off with the above-described configuration, one pair of switching elements 6a for parallel-off connected to the positive side and negative side of one photovoltaic string 103 are turned off, which parallels off the one photovoltaic string 103 from the solar energy generator system 100.

The switch 7 for measurement is located between the photovoltaic strings 103 and the measurement section 3 to switch the photovoltaic strings 103 between electrically connected and electrically unconnected. The switch 7 for measurement includes a plurality of switching elements 7a for measurement which are connected in series with the positive poles and negative poles, respectively, of the photovoltaic strings 103. Each switching element 7a for measurement is connected to the arithmetic control section 4 and switches between on and off in accordance with an instruction signal from the arithmetic control section 4. The switching element 7a for measurement here is turned off and placed in an electrically cut-off state in normal times and is turned on and placed in an electrically connected state at the time of ground fault detection.

Of terminals on the measurement section 3 side of the plurality of switching elements 7a for measurement, positive ones are connected together into a positive bus while negative ones are connected together into a negative bus. The positive bus and negative bus are connected to the measurement section 3. As the switching element 7a for measurement, a semiconductor switch such as an FET or a mechanical switch such as a relay switch can be used.

In the switch 7 for measurement with the above-described configuration, when the switch 6 for parallel-off parallels off one photovoltaic string 103 from the photovoltaic string 103, one pair of switching elements 7a for measurement connected to the positive side and negative side of the one photovoltaic string 103 are turned on, which allows the one paralleled-off photovoltaic string 103 to be measured by the measurement section 3.

As shown in Figures 1 and 3, the measurement section 3 is intended to measure a paralleled-off photovoltaic string for ground fault detection and includes a polarity selector switch 8, a sensing resistor 9, and a voltage detector 10. The polarity selector switch 8 is intended to switch between connection to the positive sides of the photovoltaic strings 103 and connection to the negative sides and includes a positive switching element 8x and a negative switching element 8y. The positive switching element 8x is electrically connected to the positive bus for the photovoltaic strings 103 while the negative switching element 8y is electrically connected to the negative bus for the photovoltaic strings 103.

The positive switching element 8x and negative switching element 8y are connected to the arithmetic control section 4 and each switch between on and off in accordance with an instruction signal from the arithmetic control section 4. As the positive switching element 8x and negative switching element 8y, semiconductor switches such as an FET or mechanical switches such as a relay switch can be used.

The sensing resistor 9 is connected between the polarity selector switch 8 and a ground potential (the earth or ground) G More specifically, one side of the sensing resistor 9 is electrically connected to the ground potential G and is grounded. The other side of the sensing resistor 9 is electrically connected to the polarity selector switch 8, i.e., electrically connected to the switching section 2 via the polarity selector switch 8. A resistance value of the sensing resistor 9 is appropriately set according to, for example, an insulation resistance value within a detection range (to be described later) and an allowed detection time.

The voltage defector 10 is electrically connected between the polarity selector switch 8 and the sensing resistor 9 and between the sensing resistor 9 and the ground potential G to measure a value of a voltage drop across the sensing resistor 9 and a sign of the value. The sign of the voltage drop value can be set, for example, such that the sign is positive when a direction of the voltage drop is a direction in which a current flows toward the ground potential G and is negative when the direction is a reverse direction. The voltage detector 10 is connected to the positive bus and negative bus for the photovoltaic strings 103 at respective positions closer to the switching section 2 than the polarity selector switch 8 to measure a potential difference (hereinafter referred to as an "interpolar voltage value") between the positive pole and the negative pole of the paralleled-off photovoltaic string 103 and a sign of the value. The sign of the interpolar voltage value can be set by, for example, comparing the magnitude of a potential on the positive side with the magnitude of a potential on the negative side. The voltage detector 10 is connected to the arithmetic control section 4 and performs various measurements in accordance with an instruction signal from the arithmetic control section 4. The voltage detector 10 stores results of the measurements in the storage section 5.

The measurement section 3 with the above-described configuration performs the measurement below on the photovoltaic string 103 paralleled off by the switching section 2 in accordance with an instruction signal from the arithmetic control section 4. That is, the measurement section 3 turns on the positive switching element 8x and turns off the negative switching element 8y, thereby connecting the positive side to the sensing resistor 9 and placing the negative side in an unconnected state (released state). The measurement section 3 measures a voltage drop across the sensing resistor 9 as a first voltage drop value. Also, the measurement section 3 turns off the positive switching element 8x and turns on the negative switching element 8y, thereby making the positive side unconnected and making the negative side connected to the sensing resistor 9. The measurement section 3 measures a voltage drop across the sensing resistor 9 as a second voltage drop value. Additionally, the measurement section 3 turns off both the switching elements 8x and 8y, thereby making the positive side and negative side unconnected and measures an interpolar voltage value.

The arithmetic control section 4 is a unit (computer) intended to control the entire ground fault detection device 1 and detect a ground fault by performing calculation on the basis of a measurement result from the measurement section 3 and executes a ground fault detection program. The arithmetic control section 4 here controls parallel-off/connection of the photovoltaic string 103, calculation and storage of an insulation resistance value, and determination of the presence or absence of a ground fault. The arithmetic control section 4 is connected to the switching section 2, the measurement section 3, and the storage section 5. The arithmetic control section 4 may be composed of a CPU (Central Processing Unit) or may be composed of an analog IC circuit or a PLD (Programmable LogicDevice) circuit.

As shown in Figure 4, the arithmetic control section 4 includes a string selection function of selecting the photovoltaic string 103 serving as a ground fault detection target, a parallel-off control function of controlling parallel-off of the photovoltaic strings 103 by instructing the switch 6 for parallel-off of the switching section 2 to switch between on and off, a measurement instruction function of instructing the switch 7 for measurement of the switching section 2 and the polarity selector switch 8 of the measurement section 3 to switch between on and off and instructing the voltage detector 10 to perform various measurements, a storage function of storing measurement statuses of the photovoltaic strings 103, a measurement result from the voltage detector 10, and a calculation result in the storage section 5, an insulation resistance calculation function of calculating an insulation resistance value on the basis of results stored in the storage section 5, and a ground fault determination function of determining the presence or absence of a ground fault.

The storage section 5 is intended to store the ground fault detection program to be executed by the arithmetic control section 4, a measurement result from the measurement section 3, and a calculation result from the arithmetic control section 4. Note that a semiconductor memory, a magnetic storage device, or the like can be used as the storage section 5. If all or part of the ground fault detection program is not stored in the storage section 5, all or part of the ground fault detection program may be stored in an external storage device (e.g., a hard disk), and the arithmetic control section 4 may perform ground fault detection by loading the all or part.

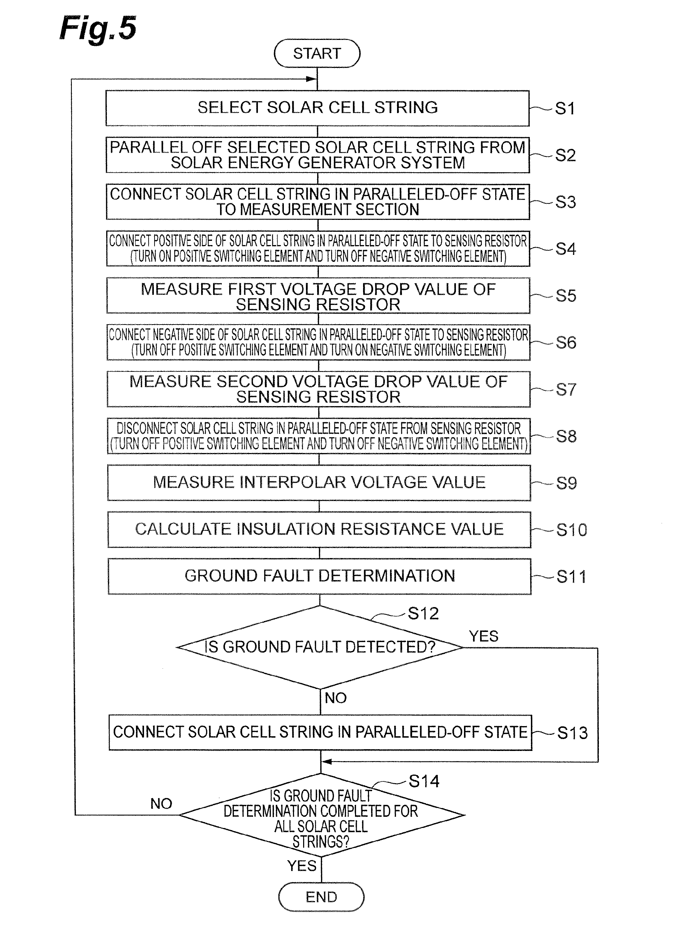

A ground fault detection method to be performed by the ground fault detection device 1 (the operation of the ground fault detection program) will be described with reference to the flow chart in Figure 5.

At the time of ground fault detection within the photovoltaic array 101 of the solar energy generator system 100, the above-described ground fault detection device 1 performs the processing below by performing the various functions of the arithmetic control section 4 and performs ground fault detection for each photovoltaic string 103.

That is, the ground fault detection device 1 first selects one photovoltaic string 103 from among the plurality of photovoltaic strings (S1). The ground fault detection device 1 turns off the switching elements 6a for parallel-off corresponding to the positive side and negative side of the selected one photovoltaic string 103. With this operation, the ground fault detection device 1 electrically disconnects and parallels off the one photovoltaic string 103 from the solar energy generator system 100 and places the photovoltaic string 103 in a paralleled-off state (S2).

The ground fault detection device 1 turns on the switching elements 7a for measurement corresponding to the positive side and negative side of the photovoltaic string 103 in a paralleled-off state and connects the photovoltaic string 103 to the measurement section 3 (S3). For the photovoltaic string 103 in a paralleled-off state, the ground fault detection device 1 turns on the positive switching element 8x and turns off the negative switching element 8y, and connects only the positive side to the other side of the sensing resistor 9 and releases the negative side (S4). In this state, the ground fault detection device 1 measures the first voltage drop value of the sensing resistor 9 and the sign of the value by the voltage detector 10 and stores a result of the measurement in the storage section 5 (S5).

For the photovoltaic string 103 in a paralleled-off state, the ground fault detection device 1 also turns off the positive switching element 8x and turns on the negative switching element 8y, and connects only the negative side to the other side of the sensing resistor 9 and releases the positive side (S6). In this state, the ground fault detection device 1 measures the second voltage drop value of the sensing resistor 9 and the sign of the value by the voltage detector 10 and stores a result of the measurement in the storage section 5 (S7).

For the photovoltaic string 103 in a paralleled-off state, the ground fault detection device 1 further turns off both of the positive switching element 8x and the negative switching element 8y and makes the positive and negative sides not connected to the sensing resistor 9 (disconnects the positive and negative sides from the sensing resistor 9). In this state, the ground fault detection device 1 measures the interpolar voltage value of the photovoltaic string 103 and the sign of the value by the voltage detector 10 and stores a result of the measurement in the storage section 5 (S8 and S9). Note that S4 and S5 described above, S6 and S7 described above, and S8 and S9 described above are in no particular order. S6 and S7 described above may be first performed or S8 and S9 described above may be first performed.

The ground fault detection device 1 calculates an insulation resistance value using the first and second voltage drop values, the interpolar voltage value, and signs that are measured (S10). More specifically, the ground fault detection device 1 calculates an insulation resistance value $R_{leak}$ using Expression (1) below.

$$R_{leak} = R_d \times |V_0/(V_1 - V_2)| - R_d \quad \dots (1)$$

where $R_d$ is a resistance value of the sensing resistor, $V_0$ is an interpolar voltage value, $V_1$ is a first voltage drop value, and $V_2$ is a second voltage drop value.

The ground fault detection device 1 compares the calculated insulation resistance value $R_{leak}$ with a reference

resistance value stored in advance in the storage section 5 and performs ground fault determination (S11). More specifically, if the calculated insulation resistance value $R_{leak}$ is not less than the reference resistance value, the ground fault detection device 1 determines that "there is no ground fault." On the other hand, if the calculated insulation resistance value $R_{leak}$ is less than the reference resistance value, the ground fault detection device 1 determines that "there is a ground fault."

If a result of the ground fault determination shows that "there is no ground fault," the ground fault detection device 1 turns on the switching elements 6a for parallel-off for the photovoltaic string 103 in a paralleled-off state to connect the photovoltaic string 103 to the solar energy generator system 100 and turns off the switching elements 7a for measurement for the photovoltaic string 103 to disconnect the photovoltaic string 103 from the measurement section 3. On the other hand, if the result of the ground fault determination shows that "there is a ground fault," the ground fault detection device 1 keeps the switching elements 6a for parallel-off for the photovoltaic string 103 in a paralleled-off state off to keep the photovoltaic string 103 in a paralleled-off state and turns off the switching elements 7a for measurement for the photovoltaic string 103 to disconnect the photovoltaic string 103 from the measurement section 3 (S12 and S13).

If measurement of the insulation resistance value $R_{leak}$ is not completed for all the photovoltaic strings 103, the flow shifts to S 1 described above, and the ground fault detection device 1 goes on to sequentially perform S1 to S13 described above for the photovoltaic string(s) 103, for which the insulation resistance value $R_{leak}$ is not measured. On the other hand, if measurement of the insulation resistance value $R_{leak}$ is completed for all the photovoltaic strings 103, the ground fault detection device 1 ends the ground fault detection (S14).

As has been described above, at the time of ground fault detection within the photovoltaic array 101 in the present embodiment, each of the photovoltaic strings 103 constituting the photovoltaic array 101 is paralleled off from the solar energy generator system 100, and ground fault detection is performed on the photovoltaic string 103 in a paralleled-off state. As described above, since ground fault detection is performed on a ground fault detection target which is set to be small, the capacitance of an earth capacitance of the ground fault detection target can be reduced (i.e., an electric circuit of the ground fault detection target can be shortened, and the total area of the electric circuit can be reduced). This can inhibit ground fault detection from being adversely affected by a current flowing due to the earth capacitance.

Additionally, the photovoltaic string 103 is electrically disconnected from the power conditioner 102 at the time of ground fault detection. This can inhibit ground fault detection from being adversely affected by noise arising from the power conditioner 102. According to the present embodiment, it is thus possible to reliably detect a ground fault.

In the present embodiment, a predetermined waiting time may be interposed in the fro S13 described above to S1 described above. That is, the arithmetic control section 4 may interpose a predetermined waiting time (a first waiting time) between when a first photovoltaic string 103 is paralleled off from the measurement section 3 after the first photovoltaic string 103 is paralleled off from the solar energy generator system 100 and connected to the measurement section 3, and ground fault detection of the first photovoltaic string 103 is performed and when a second photovoltaic string 103 is paralleled off from the solar energy generator system 100 and connected to the measurement section 3. With the provision of the first waiting time, for example, a phenomenon can be prevented in which the plurality of photovoltaic strings 103 are connected in parallel to the measurement section 3 due to, e.g., a malfunction of the switching section 2 to cause an unexpected current flow.

Additionally, with the provision of the first waiting time, all the photovoltaic strings 103 can be connected to the solar energy generator system 100 to contribute to electric power generation during the first waiting time even if the photovoltaic strings 103 are paralleled off from the solar energy generator system 100. This allows reduction in loss of electric power output (power generation capacity per predetermined time) . Note that the first photovoltaic string 103 means one photovoltaic string 103 among the plurality of photovoltaic strings 103 and that the second photovoltaic string 103 means one photovoltaic string 103 different from the first photovoltaic string 103 among the plurality of photovoltaic strings 103.

In the embodiment, a predetermined waiting time (a second waiting time) may be inserted after S3 described above. In other words, there may be the second waiting time between when the measurement section 3 is connected to the photovoltaic string 103 in a paralleled-off state and when ground fault detection is started. In this case, the first and second voltage drop values $V_1$ and $V_2$ can be measured after the values become constant (settle down). That is, for example, electric charge accumulated in an earth capacitance can be discharged during the second waiting time, which allows inhibition of erroneous detection of a ground fault due to an inrush current resulting from an earth capacitance of the photovoltaic string 103.

In a general case where ground fault detection is performed by monitoring for zero-phase currents, since a zero-phase current does not flow without a ground fault, advance sensing of defective insulation to the earth which causes a current to flow into a toucher or the like may be difficult. In this respect, as described above, the present embodiment measures the first and second voltage drop values $V_1$ and $V_2$ and determines the presence or absence of a ground fault using the insulation resistance value $R_{leak}$ calculated from the first and second voltage drop values $V_1$ and $V_2$, instead of performing ground fault detection by monitoring for zero-phase currents, and can favorably sense defective insulation to the earth in advance. It is also possible to sense a ground fault spot from the balance between the first and second voltage drop values $V_1$ and $V_2$.

At the time of switching by the polarity selector switch 8, an inrush current due to an earth capacitance may be generated to interfere with accurate quick measurement of the first and second voltage drop values $V_1$ and $V_2$. As described above, the present embodiment performs ground fault detection on the photovoltaic string 103 in a paralleled-off state and can reduce the capacitance of an earth capacitance of a ground fault detection target. This allows inhibition of the interference.

As described above, the present embodiment can perform ground fault detection of the photovoltaic string 103 only by measuring the first and second voltage drop values $V_1$ and $V_2$ of the sensing resistor 9, the interpolar voltage value $V_0$, and the signs of the values. Even relatively inexpensive measuring equipment can sense the insulation resistance value $R_{leak}$ with sufficient accuracy. The present embodiment is also capable of selectively switching connection statuses of the positive side and negative side of the photovoltaic string 103 to the sensing resistor 9 by switching operation of the polarity selector switch 8. This allows enhancement of operability.

As described above, if a ground fault is not detected in the photovoltaic string 103 in a paralleled-off state, the present embodiment can electrically connect the photovoltaic string 103 to the solar energy generator system 100. That is, the photovoltaic string 103, in which no ground fault has been detected, can be automatically connected to the solar energy generator system 100.

As described above, if a ground fault is detected in the photovoltaic string 103 in a paralleled-off state, the present embodiment can keep the photovoltaic string 103 in a paralleled-off state. That is, it is possible to electrically disconnect a defectively insulated spot from the solar energy generator system 100 and enhance the safety of the solar energy generator system 100.

In the present embodiment, at the time of ground fault detection, the photovoltaic strings 103 that are not ground fault detection targets (the photovoltaic strings 103 not selected in S1 described above) are kept connected to the power conditioner 102. This allows effective electric power generation even at the time of ground fault detection.

Even if the power conditioner 102 is a transformerless type one, and the photovoltaic array 101 is connected to a grounded power system, since the present embodiment performs ground fault detection on the photovoltaic string 103 in a paralleled-off state, the present embodiment can satisfy (1) described above and reliably detect a ground fault. It is thus possible to reliably detect a ground fault, regardless of whether the power conditioner 102 connected to the photovoltaic array 101 is an isolated type one or a non-isolated type one, and meet diversified needs of users.

As described above, the present embodiment can obtain the insulation resistance value $R_{leak}$ using one sensing resistor 9, which eliminates the need for "high-accuracy calibration of a plurality of sensing resistors 9" that is required to obtain the insulation resistance value $R_{leak}$ using the plurality of sensing resistors 9. This allows easy reduction of an error in the insulation resistance value $R_{leak}$.

Note that, in S8 and S9 described above, the interpolar voltage value $V_0$ of the paralleled-off photovoltaic string 103 may be measured by turning on the positive switching element 8x and turning off the negative switching element 8y, may be measured by turning off the positive switching element 8x and turning on the negative switching element 8y, or may be measured by turning off both the switching elements 8x and 8y.

Although the present embodiment includes one sensing resistor 9 and measures voltage drops across the sensing resistor 9 as the first and second voltage drop values $V_1$ and $V_2$, a first sensing resistor which is connected to the positive sides of the photovoltaic strings 103 and a second sensing resistor which is connected to the negative sides may be provided, a voltage drop across the first sensing resistor may be measured as the first voltage drop value $V_1$, and a voltage drop across the second sensing resistor may be measured as the second voltage drop value $V_2$.

It is also possible to directly select the photovoltaic string 103 and its poles to be connected to the sensing resistor 9 by omitting the positive switching element 8x and negative switching element 8y and appropriately switching the switching elements 7a for measurement between on and off.

The string selection function and the parallel-off control function in the above description constitute a parallel-off function (i.e., a function of electrically disconnecting and paralleling off the photovoltaic string 103 from the solar energy generator system 100 by the switching section 2) in the claims. The measurement instruction function, the storage function, the insulation resistance calculation function, and the ground fault determination function in the above description constitute a detection function (i.e., a function of performing ground fault detection on the photovoltaic string 103 in a paralleled-off state by the measurement section 3 and arithmetic control section 4) in the claims.

[Second Embodiment]

A second embodiment of the present invention will be described. Note that differences from the first embodiment described above will be mainly given in a description of the present embodiment.

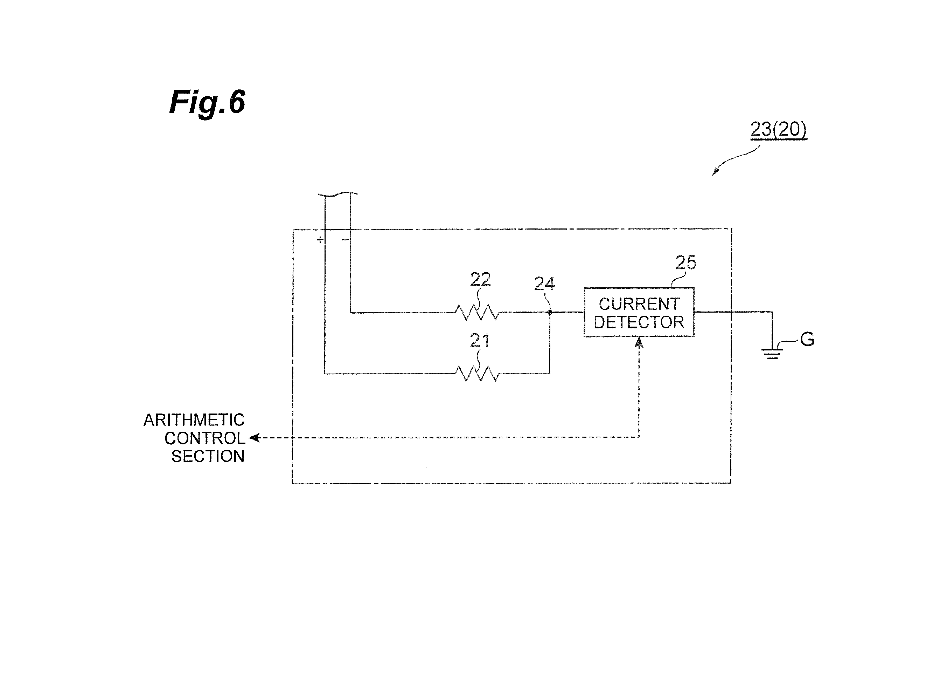

Figure 6 is a schematic configuration diagram showing a measurement section of a ground fault detection device according to the second embodiment. As shown in Figure 6, a ground fault detection device 20 according to the present embodiment is different from the ground fault detection device 1 described above in that the ground fault detection device 20 includes a measurement section 23 instead of the measurement section 3 (see Figure 3).

The measurement section 23 includes first and second sensing resistors 21 and 22 whose one sides are connected to each other and a current detector 25 which is connected between a junction (connection section) 24 of the first and second sensing resistors 21 and 22 and a ground potential G. The other side (the opposite side from the junction 24) of the first sensing resistor 21 is electrically connected to a positive bus for photovoltaic strings 103. The other end (the opposite side from the junction 24) of the second sensing resistor 22 is electrically connected to a negative bus for the photovoltaic strings 103.

The current detector 25 is intended to measure a current value (hereinafter referred to as a "leakage current value $I_{leak2}$") of a leakage current (i.e., a sneak current or a zero-phase current) which flows between the first and second sensing resistors 21 and 22 and the ground potential G. As the current detector 25, a DC zero-phase current detector or the like using a Hall element is used. The current detector 25 is connected to an arithmetic control section 4 and performs measurement of the leakage current value $I_{leak2}$ in accordance with an instruction signal from the arithmetic control section 4. The current detector 25 stores a result of the measurement in a storage section 5.

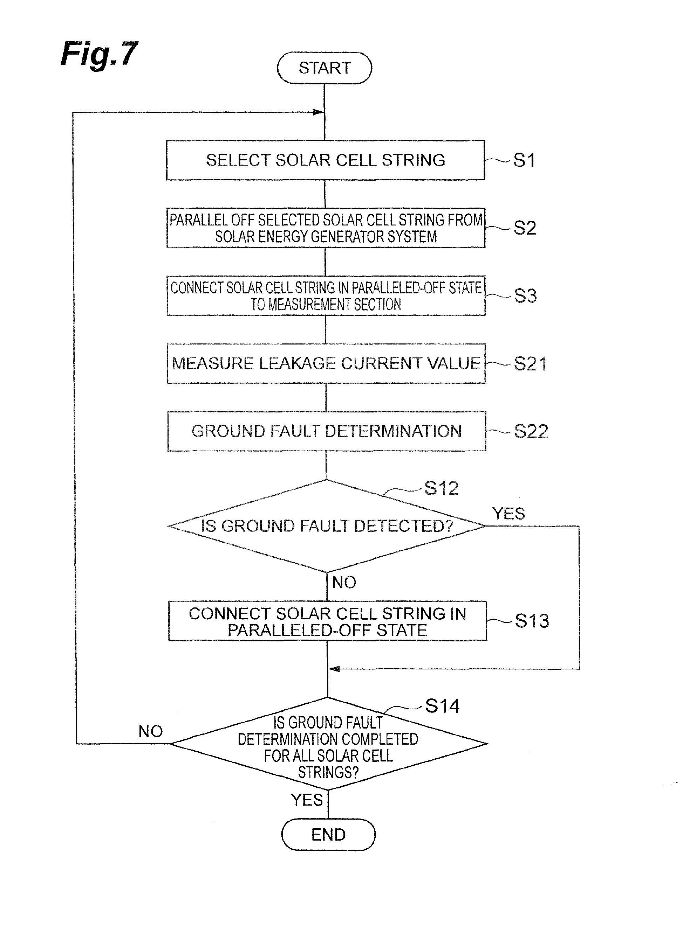

In the present embodiment with the above-described configuration, as shown in the flow chart in Figure 7, after the photovoltaic string 103 in a paralleled-off state is connected to the measurement section 23 (after S3 described above), the leakage current value $I_{leak2}$ is measured and is stored in the storage section 5 (S21). The stored leakage current value $I_{leak2}$ is compared with a reference current value stored in advance in the storage section 5, and ground fault determination is performed (S22). More specifically, if the leakage current value $I_{leak2}$ exceeds the reference current value, it is determined that "there is a ground fault." On the other hand, if the leakage current value $I_{leak2}$ is not more than the reference current value, it is determined that "there is no ground fault." If a result of the ground fault determination shows that "there is no ground fault," the flow shifts to S13 described above. On the other hand, if the result shows that "there is a ground fault," the flow shifts to S 14 described above (S22).

As has been described above, the present embodiment also parallels off the photovoltaic string 103 from a solar energy generator system 100 and performs ground fault detection on the photovoltaic string 103 in a paralleled-off state. The same advantageous effect as the above-described advantageous effect of reliably detecting a ground fault can thus be produced.

As described above, the present embodiment determines the presence or absence of a ground fault on the basis of the leakage current value $I_{leak2}$. Ground fault detection can thus be performed on the photovoltaic string 103 in a paralleled-off state by monitoring the leakage current value $I_{leak2}$. Additionally, voltage application is unnecessary at the time of ground fault detection, and safety at the time of ground fault detection can be ensured.

In a general case where ground fault detection is performed by monitoring the leakage current value $I_{leak2}$, if the solar energy generator system 100 has a large capacitance (earth capacitance) to the ground potential G, a long time may be required for a potential difference between the solar energy generator system 100 and the ground fault detection device 1 to reach a fixed value or ground fault detection before the potential difference reaches the fixed value may cause an error. In contrast, if the photovoltaic strings 103 are paralleled off and subjected to detection one at a time, as in the present embodiment, the problem can be avoided, and ground fault detection can be reliably performed in a short time.

Note that resistance values of the first and second sensing resistors 21 and 22 are set to be not less than a predetermined lower limit from the standpoint of safety in the event of a ground fault and are set to be not more than a predetermined upper limit from the standpoint of the detectability of the leakage current value $I_{leak2}$.

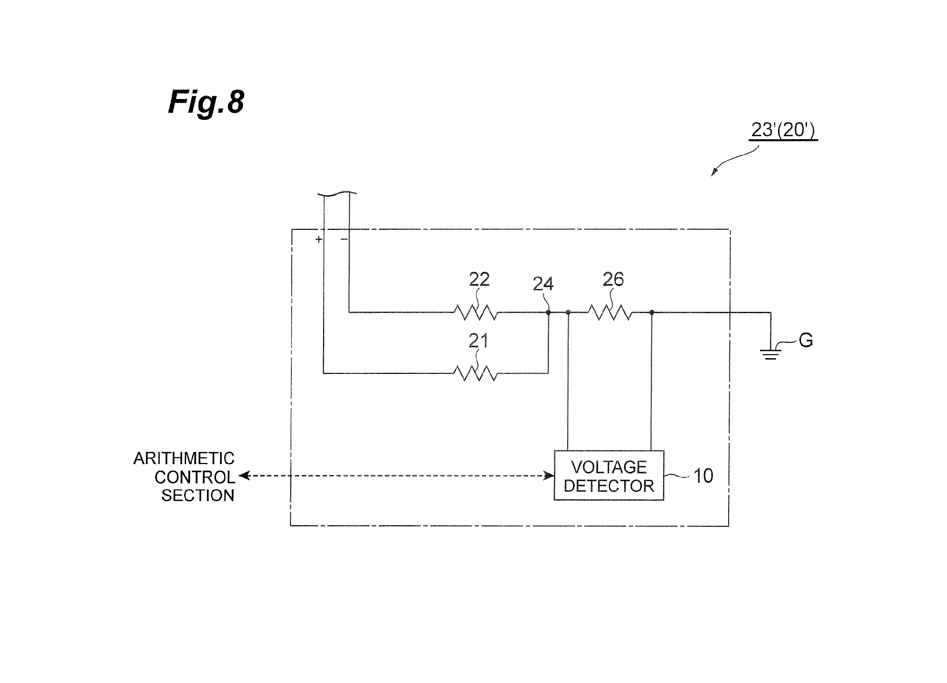

Figure 8 is a schematic configuration diagram showing a measurement section of a ground fault detection device according to a modification of the second embodiment. As shown in Figure 8, a ground fault detection device 20' according to the modification is different from the ground fault detection device 1 described above in that the ground fault detection device 20' includes a measurement section 23' instead of the measurement section 23 (see Figure 6). In the measurement section 23', a third sensing resistor 26 is connected between the junction 24 of the first and second sensing resistors 21 and 22 and the ground potential G The voltage detector 10 is electrically connected between the junction 24 and the sensing resistor 26 and between the sensing resistor 26 and the ground potential G. A voltage value $V_{leak2}$ of the sensing resistor 26 is measured by the voltage detector 10.

The ground fault detection device 20' can measure the voltage value $V_{leak2}$ in the third sensing resistor 26 by the voltage detector 27, store the voltage value $V_{leak2}$, and calculate a leakage current value $I_{leak2}$ by Expression (2) below in S21 described above. Since the voltage detector 10 is generally high in measurement accuracy than the current detector 25, if the current value $I_{leak2}$ is obtained by measuring the voltage value $V_{leak2}$ as in the present embodiment, the current value $I_{leak2}$ can be achieved with high accuracy. This allows high-accuracy detection of a ground fault.

$$I_{leak2} = V_{leak2}/R_2 \qquad \ldots (2)$$

where $R_2$ is a resistance value of the third sensing resistor 26.

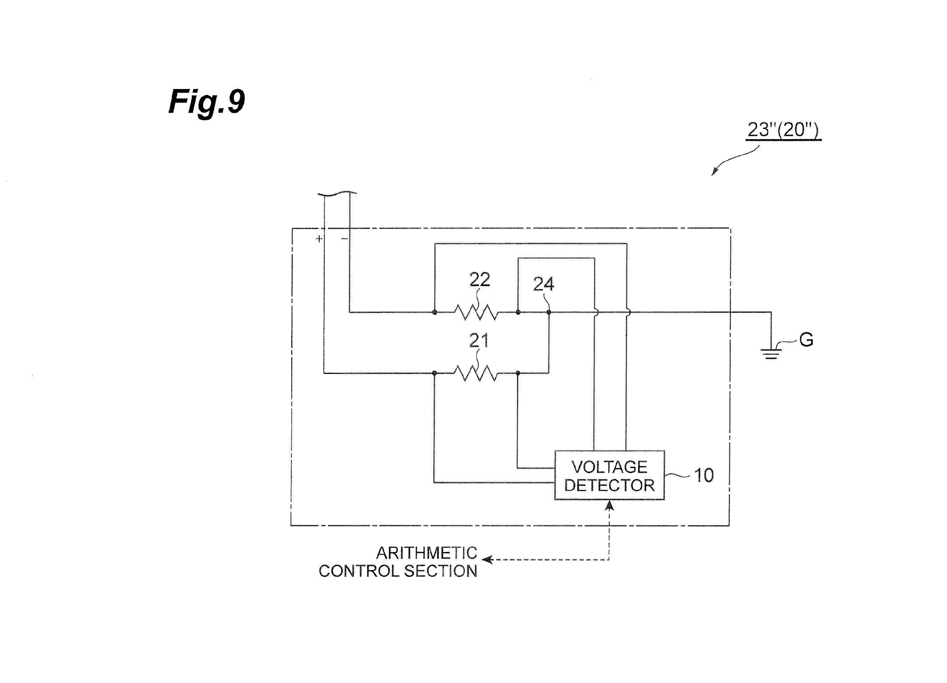

Figure 9 is a schematic configuration diagram showing a measurement section of a ground fault detection device according to a different modification of the second embodiment. As shown in Figure 9, a ground fault detection device 20" according to the different modification is different from the ground fault detection device 1 described above in that the ground fault detection device 20" includes a measurement section 23" instead of the measurement section 23 (see Figure 6). In the measurement section 23", the junction 24 of the first and second sensing resistors 21 and 22 is directly connected to the ground potential G. The voltage detector 10 is electrically connected between a switching section 2 and the sensing resistor 21 and between the sensing resistor 21 and the junction 24. A voltage value $V_{21}$ of the sensing resistor 21 is measured by the voltage detector 10. The voltage detector 10 is also electrically connected between the switching section 2 and the sensing resistor 22 and between the sensing resistor 22 and the junction 24. A voltage value $V_{22}$ of the sensing resistor 22 is measured by the voltage detector 10.

The ground fault detection device 20" can measure the voltage values $V_{21}$ and $V_{22}$ by the voltage detector 10, record the voltage values $V_{21}$ and $V_{22}$, and calculate a leakage current value $I_{leak2}$ by Expression (3) below in S21 described above. Since the voltage detector 10 is generally high in measurement accuracy than the current detector 25, if the current value $I_{leak2}$ is obtained by measuring the voltage values $V_{21}$ and $V_{22}$ as in the present embodiment, the current value $I_{leak2}$ can be achieved with high accuracy. This allows high-accuracy detection of a ground fault.

$$I_{leak2} = |V_{21}/R_{21}| - |V_{22}/R_{22}| \qquad ... (3)$$

where $R_{21}$ is a resistance value of the first sensing resistor 21, and $R_{22}$ is a resistance value of the second sensing resistor 22.

[third Embodiment]

A third embodiment of the present invention will be described. Note that differences from the first embodiment described above will be mainly given in a description of the present embodiment.

Figure 10 is a schematic configuration diagram showing a switching section of a ground fault detection device according to the third embodiment. Figure 11 is a schematic configuration diagram showing a measurement section of the ground fault detection device according to the third embodiment. As shown in Figures 10 and 11, a ground fault detection device 30 according to the present embodiment is different from the ground fault detection device 1 described above in that the ground fault detection device 30 includes a switching section 32 instead of the switching section 2 (see Figure 2) and includes a measurement section 33 instead of the measurement section 3 (see Figure 3).

As shown in Figure 10, the switching section 32 includes a switch 37 for measurement. The switch 37 for measurement includes a plurality of switching elements 7a for measurement which are connected in series with positive poles of photovoltaic strings 103. Of terminals on the measurement section 33 side of the plurality of switching elements 7a for measurement, positive ones are connected together into a positive bus.

As shown in Figure 11, the measurement section 33 includes an AC power supply 31 whose one side is connected to a ground potential G via a current detector 25. The AC power supply 31 is intended to apply an AC voltage (AC bias) with an AC voltage value $V_{Asource}$ to the photovoltaic strings 103. The other side of the AC power supply 31 is electrically connected to the positive bus for the photovoltaic strings 103. Note that the voltage amplitude of the AC voltage value $V_{Asource}$ is set to be not less than a predetermined lower limit from the standpoint of enhancing the sensitivity of ground fault detection and set to be not more than a predetermined upper limit from the standpoint of preventing breakage of an electric circuit. The AC voltage value $V_{Asource}$ here is set to a voltage value comparable to a voltage value of one photovoltaic string 103, as a preferred value.

The AC power supply 31 is connected to an arithmetic control section 4 and applies the AC voltage value $V_{Asource}$ in accordance with an instruction signal from the arithmetic control section 4. The AC power supply 31 also stores a waveform of the AC voltage value $V_{Asource}$ in a storage section 5. The current detector 25 measures a value $I_{leak3}$ of a leakage current which flows between the AC power supply 31 and the ground potential G.

In the present embodiment with the above-described configuration, as shown in the flow chart in Figure 12, after the photovoltaic string 103 in a paralleled-off state is connected to the measurement section 33 (after S3 described above), the leakage current value $I_{leak3}$, the AC voltage value $V_{Asource}$, and waveforms of the values are measured and are stored in the storage section 5 (S31). An insulation resistance value $R_{leak}$ is calculated on the basis of the stored measurement results (S32).

More specifically, the leakage current value $I_{leak3}$ is first separated into a leakage current value $I_{leak3-R}$ which is a component in phase with the AC voltage value $V_{Asource}$ and a leakage current value $I_{leak3-C}$ which is a component 90° out of phase with the AC voltage value $V_{Asource}$. The insulation resistance value $R_{leak}$ is calculated by dividing the AC voltage value $V_{Asource}$ by the leakage current value $I_{leak3-R}$. This is because if the dielectric loss of an insulating material used is low, and a dielectric loss between the photovoltaic string 103 and the ground potential G is negligible, the leakage current value $I_{leak3-R}$ can be regarded as a current which flows due to imperfect insulation. The calculated insulation resistance value $R_{leak}$ is compared with a reference resistance value stored in advance in the storage section 5, and the flow shifts to S11 described above for ground fault determination.

Note that if the dielectric loss between the photovoltaic string 103 and the ground potential G is not negligible, the insulation resistance value $R_{leak}$ can be obtained by the method below. First, in S31 described above, the waveform of the leakage current value $I_{leak3}$ and the waveform of the AC voltage value $V_{Asource}$ are measured at a plurality of applied frequencies and are stored. In S32 described above, the insulation resistance value $R_{leak}$ is obtained by calculating a value of the leakage current value $I_{teak3-R}$ at a frequency of 0 by extrapolation. More specifically, let f be an applied frequency. The leakage current value $I_{leak3-R}$ is plotted against frequency. The leakage current value $I_{leask3-R}$ at f = 0 is obtained as a leakage current value $I_{leak3-R0}$, and the insulation resistance value $R_{leak}$ is obtained by diving the AC voltage value $V_{Asource}$ by the leakage current value $I_{leak3-R0}$.

As has been described above, the present embodiment also parallels off the photovoltaic strong 103 from a solar energy generator system 100 and performs ground fault detection on the photovoltaic string 103 in a paralleled-off state. The same advantageous effect as the above-described advantageous effect of reliably detecting a ground fault can thus be produced.

As described above, the present embodiment determines the presence or absence of a ground fault on the basis of the current value $I_{leak3-R}$ in phase with the AC voltage value $V_{Asource}$ of the leakage current value $I_{leak3}$. Ground fault detection can thus be performed on the photovoltaic string 103 in a paralleled-off state by monitoring the current value $I_{leak3-R}$.

In a general case where ground fault detection is performed by applying an AC voltage between a photovoltaic array 101 and the ground potential G and monitoring the leakage current value $I_{leak3-C}$ in phase with the AC voltage value $V_{Asource}$, the leakage current value $I_{leak3-C}$ 90° out of phase with the applied AC voltage value $V_{Asource}$ needs to be removed by calculation processing. However, if a ground fault detection target has a large earth capacitance, the leakage current value $I_{leak3-C}$ is large. Sufficient removal by the calculation processing may be difficult to cause an error in ground fault detection. In contrast, since the photovoltaic strings 103 are paralleled off and subjected to ground fault detection one at a time in the present embodiment, an earth capacitance can be reduced. This allows avoidance of the problem and reliable ground fault detection.

Since the photovoltaic string 103 is paralleled off and subjected to ground fault detection, as described above, an AC voltage from the AC power supply 31 is prevented from being applied to a power conditioner 102. This can inhibit parts within the power conditioner 102 such as a surge absorber and an earth capacitor from being strained or being reduced in life. It is thus possible to prevent breakage of equipment.

Note that, in S31 described above, the measurement may be performed at a plurality of frequencies for easy calculation of the leakage current value $I_{leak3}$ in S32 described above.

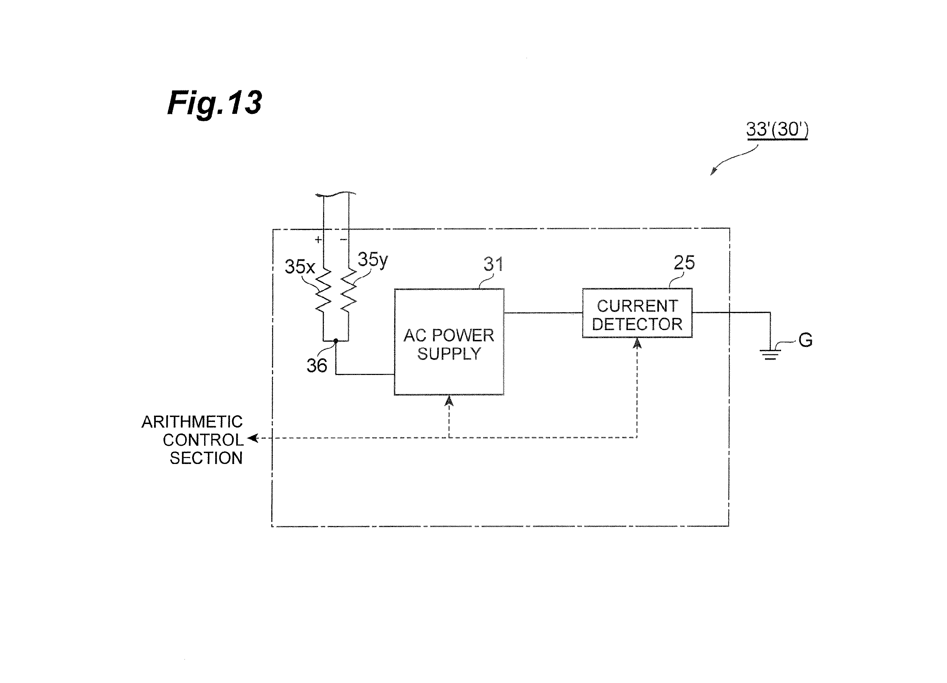

Figure 13 is a schematic configuration diagram showing a measurement section in a ground fault detection device according to a modification of the third embodiment. A ground fault detection device 30' according to the modification is different from the ground fault detection device 30 described above in that the ground fault detection device 30' includes a switching section 2 described above (see Figure 2) instead of the switching section 32 (see Figure 10) and, as shown in Figure 13, includes a measurement section 33' instead of the measurement section 33 (see Figure 11).

In the measurement section 33', one side of the AC power supply 31 is connected to the ground potential G via the current detector 25. The other side of the AC power supply 31 is connected to a midpoint 36 between sensing resistors 35x and 35y which divide a voltage across the photovoltaic string 103. That is, a positive bus and a negative bus for the photovoltaic strings 103 are connected at the midpoint 36 via the sensing resistors 35x and 35y, respectively, and the midpoint 36 is connected to the other side of the AC power supply 31.

The ground fault detection device 30' according to the modification can obtain an insulation resistance value $R_{leak}$ of the photovoltaic string 103 by Expression (4) below in consideration of effects of partial resistances in S32 described above. The presence of the sensing resistors 35x and 35y allows reduction in the magnitude of leakage current value $I_{leak}$ and enhancement of safety.

$$R_{leak} = V_{Asource}/I_{leak3-R} - 1/\{(1/R_{31})+(1/R_{32})\}$$

or

$$R_{leak} = V_{Asource}/I_{leak3-R0} - 1/\{(1/R_{31})+(1/R_{32})\} \quad ...(4)$$

where $R_{31}$ is a resistance value of the sensing resistor 35x, and $R_{32}$ is a resistance value of the sensing resistor 35y.

Figure 14 is a schematic configuration diagram showing a measurement section in a ground fault detection device according to a different modification of the third embodiment. As shown in Figure 14, a ground fault detection device 30" according to the different modification is different from the ground fault detection device 30 described above in that the ground fault detection device 30" includes a measurement section 33" instead of the measurement section 33 (see Figure 11).

In the measurement section 33", one side of the AC power supply 31 is connected to the ground potential G via a sensing resistor 38. The other side of the AC power supply 31 is connected to a positive bus for the photovoltaic strings 103. A voltage detector 10 is electrically connected between the AC power supply 31 and the sensing resistor 38 and between the sensing resistor 38 and the ground potential G. A voltage value of the sensing resistor 38 is measured by the voltage defector 10.

The ground fault detection device 30" according to the different modification measures and stores a waveform of a voltage value $V_{leak3}$ which is generated in the sensing resistor 38 in S31 described above. In S32 described above, the ground fault detection device 30" can calculate a leakage current value $Il_{eak3-R}$ by dividing the voltage value $V_{leak3}$ by a resistance value $R_{33}$ of the sensing resistor 38 and handling a quotient ($V_{leak3}/R_{33}$) like a leakage current value $I_{leak3}$ and obtain an insulation resistance value $R_{leak}$ of the photovoltaic string 103 by Expression (5) below. Since the voltage detector 10 is generally high in measurement accuracy than the current detector 25, if the current value $I_{leak3}$ is obtained by measuring the voltage value $V_{leak3}$ as in the present embodiment, the current value $I_{leak3}$ can be achieved with high accuracy. This allows high- accuracy detection of a ground fault.

$$R_{leak} = V_{Asource}/I_{leak3-R} - R_{33}$$

or

$$R_{leak} = V_{Asource}/I_{leak3-R0} - R_{33} \quad ...(5)$$

[Fourth Embodiment]

A fourth embodiment of the present invention will be described. Note that differences from the third embodiment described above will be mainly given in a description of the present embodiment.

Figure 15 is a schematic configuration diagram showing a measurement section of a ground fault detection device according to the fourth embodiment. As shown in Figure 15, a ground fault detection device 40 according to the present embodiment is different from the ground fault detection device 30 described above in that the ground fault detection device 40 includes a measurement section 43 instead of the measurement section 33 (see Figure 11).

The measurement section 43 includes a DC power supply 42 which applies a voltage (DC bias) with a DC voltage value $V_{Dsource}$ to a photovoltaic string 103. One side of the DC power supply 42 is the positive side and is connected to a ground potential G via a sensing resistor 41. The other side of the DC power supply 42 is the negative side and is electrically connected to a positive bus for the photovoltaic strings 103. Note that the voltage with the DC voltage value $V_{Dsource}$ is set to be not less than a predetermined lower limit from the standpoint of enhancing the sensitivity of ground fault detection and set to be not more than a predetermined upper limit from the standpoint of preventing breakage of a solar cell circuit serving as a measurement target. The DC voltage value $V_{Dsource}$ here is set to a voltage value comparable to a voltage value of one photovoltaic string 103 as a preferred value.

The DC power supply 42 is connected to an arithmetic control section 4 and applies the DC voltage value $V_{Dsource}$ in accordance with an instruction signal from the arithmetic control section 4. The DC power supply 42 also stores the DC voltage value $V_{Dsource}$ in a storage section 5. The measurement section 43 includes a voltage detector 10 which detects a voltage value $V_{leak4}$ which is generated in the sensing resistor 41. The voltage detector 10 is electrically connected between the DC power supply 42 and the sensing resistor 4 and between the sensing resistor 41 and the ground potential G.

In the present embodiment with the above-described configuration, as shown in the flow chart in Figure 16, after the photovoltaic string 103 in a paralleled-off state is connected to the measurement section 43 (after S3 described above), the voltage value $V_{leak4}$ of the sensing resistor 41 is measured and is stored in the storage section 5 (S41). A leakage current value $I_{leak4}$ is calculated by Expression (6) below on the basis of the stored voltage value $V_{leak4}$ (S42). The calculated leakage current value $I_{leak4}$ is compared with a reference current value stored in advance in the storage section 5, and the flow shifts to S11 described above for ground fault determination.

$$I_{leak4} = V_{leak4}/R_{41} \qquad ... (6)$$

where $R_{41}$ is a resistance value of the sensing resistor 41.

As has been described above, the present embodiment also parallels off the photovoltaic string 103 from a solar energy generator system 100 and performs ground fault detection on the photovoltaic string 103 in a paralleled-off state. The same advantageous effect as the above-described advantageous effect of reliably detecting a ground fault can thus be produced.

As described above, the present embodiment determines the presence or absence of a ground fault on the basis of the value $I_{leak4}$ of a leakage current which flows from the DC power supply 42 to the ground potential G Ground fault detection can thus be performed on the photovoltaic string 103 in a paralleled-off state by monitoring the leakage current value $I_{leak4}$. Since the voltage detector 10 is generally high in measurement accuracy than the current detector 25, if the current value $I_{leak4}$ is obtained by measuring the voltage value $V_{leak4}$ as in the present embodiment, the current value $I_{leak4}$ can be achieved with high accuracy. This allows high-accuracy detection of a ground fault.

Since the photovoltaic string 103 is paralleled off and subjected to ground fault detection, as described above, a DC voltage from the DC power supply 42 is prevented from being applied to a power conditioner 102. This can inhibit parts within the power conditioner 102 such as a surge absorber and an earth capacitor from being strained or being reduced in life. It is thus possible to prevent breakage of equipment.

Note that although the other side of the DC power supply 42 is electrically connected to the positive bus for the photovoltaic strings 103 in the present embodiment, the other side of the DC power supply 42 may be electrically connected to a negative bus for the photovoltaic strings 103. In this case, one side of the DC power supply 42 is the positive side and is connected to the ground potential G via the sensing resistor 41 while the other side of the DC power supply 42 is the negative side and is electrically connected to the positive bus for the photovoltaic strings 103.

Figure 17 is a schematic configuration diagram showing a measurement section in a ground fault detection device according to a modification of the fourth embodiment. As shown in Figure 17, a ground fault detection device 40' according to the modification is different from the ground fault detection device 40 described above in that the ground fault detection device 40' includes a measurement section 43' instead of the measurement section 43 (see Figure 15). In the measurement section 43', one side of the DC power supply 42 is connected to the ground potential G via a current detector 25. The current detector 25 here measures a value $I_{leak4}$ of a leakage current which flows from the DC power supply 42 to the ground potential G.

The ground fault detection device 40' according to the modification can measure and store the leakage current value $I_{leak4}$ in S41 described above and can omit S42 described above.

The preferred embodiments of the present invention have been described above. The present invention, however, is not limited to the embodiments described above and may be modified or applied to others without departing from the scope as defined in the appended claims.

For example, the above-described embodiments include the power conditioner 102 as a load device. The load device may be a converter or a DC load such as a storage battery as long as it consumes or converts electric power. The number of photovoltaic strings 103 constituting the photovoltaic array 101 may be two or may be four or more. The number of photovoltaic modules 104 constituting each photovoltaic string 103 may be two to seven or may be nine or more.

In the above-described embodiments, the photovoltaic string 103 is paralleled off from the solar energy generator system 100. The present invention, however, is not limited to this. The photovoltaic array 101 may be paralleled off from the solar energy generator system 100, and ground fault detection may be performed on the photovoltaic array 101. In the above description, the measurement section and the arithmetic control section constitute a detection section, and the arithmetic control section constitutes a control section.

In the present invention, a plurality of photovoltaic strings 103 may be paralleled off from the solar energy generator system 100 (i.e., a plurality of photovoltaic strings 103 may be paralleled off at a time), and ground fault detection may be performed on the plurality of photovoltaic strings 103 in a paralleled-off state. In this case, the total number of ground fault detection operations at the time of ground fault detection within the photovoltaic array 101 can be made smaller than in a case where the photovoltaic strings 103 are paralleled off and subjected to ground fault detection one at a time.

**Industrial Applicability**

According to the present invention, it is possible to reliably detect a ground fault.

**Reference Signs List**

| | |
|---|---|
| 1 | ground fault detection device |
| 2, 32 | switching section |
| 3, 23, 23', 23", 33, 33', 33", 43, 43' | measurement section (detection section) |
| 4 | arithmetic control section (detection section, control section) |
| 9 | sensing resistor |
| 21 | first sensing resistor |
| 22 | second sensing resistor |
| 24 | junction of first and second sensing resistors (connection section) |
| 26 | third sensing resistor |
| 31 | AC power supply |
| 35x | first sensing resistor |
| 35y | second sensing resistor |
| 38 | sensing resistor |
| 41 | sensing resistor |
| 42 | DC power supply |
| 100 | solar energy generator system |
| 101 | photovoltaic array |
| 102 | power conditioner (load device) |
| 103 | photovoltaic string |
| 104 | photovoltaic module |
| G | ground potential |

**Claims**

1. A ground fault detection device for detecting a ground fault within a photovoltaic array in a solar energy generator system including a photovoltaic string composed of a plurality of photovoltaic modules connected in series, the photovoltaic array composed of a plurality of the photovoltaic strings connected in parallel, and a load device consuming or converting electric power, comprising:

   a switching section which parallels off the photovoltaic array or the photovoltaic string by electrically disconnecting the photovoltaic array or the photovoltaic string from the solar energy generator system; and
   a detection section which detects a ground fault in the photovoltaic array or the photovoltaic string while the photovoltaic array or the photovoltaic string is paralleled off by the switching section.

2. The ground fault detection device according to claim 1, comprising
   a control section which controls operation of the switching section and the detection section, wherein
   after the control section causes a first photovoltaic string of the plurality of photovoltaic strings to be paralleled off from the solar energy generator system and be connected to the detection section and causes the detection section to perform ground fault detection of the first photovoltaic string, the control section interposes a first waiting time between when the control section causes the first photovoltaic string to be paralleled off from the detection section and when the control section causes a second photovoltaic string of the plurality of photovoltaic strings to be paralleled off from the solar energy generator system and be connected to the detection section.

3. The ground fault detection device according to claim 1 or 2, wherein the detection section has a second waiting time between when the detection section is connected to the paralleled-off photovoltaic array or the paralleled-off photovoltaic string and when the detection section starts detection of the ground fault.

4. The ground fault detection device according to claim 1 or 2, wherein
   the detection section

includes first and second sensing resistors which are connected to each other via a connection section and determines presence or absence of the ground fault on the basis of a detection value associated with a value of a current flowing from the connection section to a ground potential while an opposite side from the connection section of the first sensing resistor is connected to a positive side of the paralleled-off photovoltaic array or the paralleled-off photovoltaic string and an opposite side from the connection section of the second sensing resistor is connected to a negative side.

5. The ground fault detection device according to claim 1 or 2, wherein
the detection section
includes an AC power supply whose one side is connected to a ground potential and
determines presence or absence of the ground fault on the basis of a detection value associated with, of a value of a current flowing from the AC power supply to the ground potential, a value of a current in phase with a value of an AC voltage from the AC power supply while the other side of the AC power supply is connected to the paralleled-off photovoltaic array or the paralleled-off photovoltaic string.

6. The ground fault detection device according to claim 1 or 2, wherein
the detection section
includes a DC power supply whose one side is connected to a ground potential and
determines presence or absence of the ground fault on the basis of a detection value associated with a value of a current flowing from the DC power supply to the ground potential while the other side as a negative side or a positive side of the DC power supply is connected to a positive side or a negative side of the paralleled-off photovoltaic array or the paralleled-off photovoltaic string.

7. The ground fault detection device according to claim 1 or 2, wherein
the detection section
includes at least one sensing resistor whose one side is connected to a ground potential,
measures a value of a voltage drop across the sensing resistor as a first voltage drop value while the other side of the sensing resistor is connected to only a positive side of the paralleled-off photovoltaic array or the paralleled-off photovoltaic string and measures a value of a voltage drop across the sensing resistor as a second voltage drop value while the other side of the sensing resistor is connected to only a negative side of the paralleled-off photovoltaic array or the paralleled-off photovoltaic string, and
determines presence or absence of the ground fault on the basis of the measured first and second voltage drop values.

8. The ground fault detection device according to any one of claims 1 to 7, wherein the switching section electrically connects the paralleled-off photovoltaic array or the paralleled-off photovoltaic string to the solar energy generator system if the ground fault is not detected by the detection section.

9. The ground fault detection device according to any one of claims 1 to 8, wherein the switching section keeps the paralleled-off photovoltaic array or the paralleled-off photovoltaic string paralleled off from the solar energy generator system if the ground fault is detected by the detection section.

10. The ground fault detection device according to any one of claims 1 to 9, wherein
the switching section parallels off a plurality of the photovoltaic strings from the solar energy generator system, and
the detection section detects a ground fault in the plurality of photovoltaic strings while the plurality of photovoltaic strings are paralleled off by the switching section.

11. A ground fault detection method for detecting a ground fault within a photovoltaic array in a solar energy generator system including a photovoltaic string composed of a plurality of photovoltaic modules connected in series, the photovoltaic array composed of a plurality of the photovoltaic strings connected in parallel, and a load device consuming or converting electric power, comprising:

a parallel-off step of paralleling off the photovoltaic array or the photovoltaic string from the solar energy generator system; and
a detection step of detecting a ground fault in the photovoltaic array or the photovoltaic string while the photovoltaic array or the photovoltaic string is paralleled off by the parallel-off step.

12. The ground fault detection method according to claim 11, comprising:

a first parallel-off step of paralleling off a first photovoltaic string of the plurality of photovoltaic strings from the solar energy generator system and connecting the first photovoltaic string to a detection section for ground fault detection;

a first detection step of performing ground fault detection of the first photovoltaic string and paralleling off the first photovoltaic string from the detection section, after the first parallel-off step;

a second parallel-off step of paralleling a second photovoltaic string of the plurality of photovoltaic strings from the solar energy generator system and connecting the second photovoltaic string to the detection section, after the first detection step; and

an interposition step of interposing a first waiting time between when the first photovoltaic string is paralleled off from the detection section by the first detection step and when the second photovoltaic string is paralleled off from the solar energy generator system and is connected to the detection section by the second parallel-off step.

13. The ground fault detection method according to claim 11 or 12, wherein the detection step has a second waiting time between when the detection section for ground fault detection is connected to the photovoltaic array or the photovoltaic string in a paralleled-off state and when the detection section starts detection of the ground fault.

14. The ground fault detection method according to any one of claims 11 to 13, further comprising a step of connecting electrically the paralleled-off photovoltaic array or the paralleled-off photovoltaic string to the solar energy generator system if the ground fault is not detected in the ground fault detection step.

15. The ground fault detection method according to any one of claims 11 to 14, further comprising a step of keeping the paralleled-off photovoltaic array or the paralleled-off photovoltaic string paralleled off from the solar energy generator system if the ground fault is detected in the ground fault detection step.

16. The ground fault detection method according to any one of claims 11 to 15, wherein
the parallel-off step comprises paralleling off a plurality of the photovoltaic strings from the solar energy generator system, and
the detection step comprises detecting a ground fault in the plurality of photovoltaic strings while the plurality of photovoltaic strings are paralleled off by the parallel-off step.

17. A solar energy generator system comprising:

a photovoltaic string which is composed of a plurality of photovoltaic modules connected in series;
a photovoltaic array which is composed of a plurality of the photovoltaic strings connected in parallel;
a load device which consumes or converts electric power; and
a ground fault detection device according to any one of claims 1 to 10.

18. A ground fault detection program for detecting a ground fault within a photovoltaic array in a solar energy generator system including a photovoltaic string composed of a plurality of photovoltaic modules connected in series, the photovoltaic array composed of a plurality of the photovoltaic strings connected in parallel, and a load device consuming or converting electric power, the ground fault detection program causing a computer to execute:

a parallel-off function of paralleling off the photovoltaic array or the photovoltaic string by electrically disconnecting the photovoltaic array or the photovoltaic string from the solar energy generator system; and
a detection function of detecting a ground fault in the photovoltaic array or the photovoltaic string while the photovoltaic array or the photovoltaic string is paralleled off.

**Fig.1**

EP 2 648 009 A1

## Fig.2

2

ARITHMETIC
CONTROL SECTION

6

6a

ARITHMETIC
CONTROL SECTION

7

7a

Fig.3

*Fig.4*

4

SWITCHING SECTION

STRING SELECTION
FUNCTION

PARALLEL-OFF CONTROL
FUNCTION

MEASUREMENT INSTRUCTION
FUNCTION

STORAGE FUNCTION

INSULATION RESISTANCE CALCULATION
FUNCTION

GROUND FAULT DETERMINATION
FUNCTION

MEASUREMENT
SECTION

STORAGE SECTION

## *Fig.5*

START

SELECT SOLAR CELL STRING — S1

PARALLEL OFF SELECTED SOLAR CELL STRING FROM SOLAR ENERGY GENERATOR SYSTEM — S2

CONNECT SOLAR CELL STRING IN PARALLELED-OFF STATE TO MEASUREMENT SECTION — S3

CONNECT POSITIVE SIDE OF SOLAR CELL STRING IN PARALLELED-OFF STATE TO SENSING RESISTOR (TURN ON POSITIVE SWITCHING ELEMENT AND TURN OFF NEGATIVE SWITCHING ELEMENT) — S4

MEASURE FIRST VOLTAGE DROP VALUE OF SENSING RESISTOR — S5

CONNECT NEGATIVE SIDE OF SOLAR CELL STRING IN PARALLELED-OFF STATE TO SENSING RESISTOR (TURN OFF POSITIVE SWITCHING ELEMENT AND TURN ON NEGATIVE SWITCHING ELEMENT) — S6

MEASURE SECOND VOLTAGE DROP VALUE OF SENSING RESISTOR — S7

DISCONNECT SOLAR CELL STRING IN PARALLELED-OFF STATE FROM SENSING RESISTOR (TURN OFF POSITIVE SWITCHING ELEMENT AND TURN OFF NEGATIVE SWITCHING ELEMENT) — S8

MEASURE INTERPOLAR VOLTAGE VALUE — S9

CALCULATE INSULATION RESISTANCE VALUE — S10

GROUND FAULT DETERMINATION — S11

IS GROUND FAULT DETECTED? — S12
YES
NO

CONNECT SOLAR CELL STRING IN PARALLELED-OFF STATE — S13

IS GROUND FAULT DETERMINATION COMPLETED FOR ALL SOLAR CELL STRINGS? — S14
NO
YES

END

## Fig.6

23(20)

22  24

25

CURRENT DETECTOR

21

ARITHMETIC CONTROL SECTION

G

EP 2 648 009 A1

EP 2 648 009 A1

**Fig.7**

```
                    ( START )
                        │
        ┌───────────────┤
        │               ▼
        │   ┌──────────────────────────┐
        │   │  SELECT SOLAR CELL STRING │──S1
        │   └──────────────────────────┘
        │               │
        │   ┌──────────────────────────────────────────┐
        │   │ PARALLEL OFF SELECTED SOLAR CELL STRING FROM │──S2
        │   │      SOLAR ENERGY GENERATOR SYSTEM          │
        │   └──────────────────────────────────────────┘
        │               │
        │   ┌──────────────────────────────────────────┐
        │   │ CONNECT SOLAR CELL STRING IN PARALLELED-OFF STATE │──S3
        │   │         TO MEASUREMENT SECTION             │
        │   └──────────────────────────────────────────┘
        │               │
        │   ┌──────────────────────────────────────┐
        │   │  MEASURE LEAKAGE CURRENT VALUE        │──S21
        │   └──────────────────────────────────────┘
        │               │
        │   ┌──────────────────────────────────────┐
        │   │   GROUND FAULT DETERMINATION          │──S22
        │   └──────────────────────────────────────┘
        │               │
        │          ╱───────────╲  S12
        │        ╱ IS GROUND FAULT ╲ ───YES──┐
        │        ╲   DETECTED?     ╱          │
        │          ╲───────────╱             │
        │              │NO                    │
        │   ┌──────────────────────────┐      │
        │   │ CONNECT SOLAR CELL STRING IN │──S13 │
        │   │    PARALLELED-OFF STATE   │      │
        │   └──────────────────────────┘      │
        │               │◄───────────────────┘
        │          ╱───────────╲  S14
        │   NO    ╱ IS GROUND FAULT ╲
        └────────╲ DETERMINATION COMPLETED
                  ╲ FOR ALL SOLAR CELL ╱
                   ╲   STRINGS?     ╱
                     ╲───────────╱
                        │YES
                     ( END )
```

25

EP 2 648 009 A1

# Fig.8

23'(20')

22   24   26

21

G

ARITHMETIC
CONTROL  ◀----------------------------▶  VOLTAGE
SECTION                                  DETECTOR   10

# Fig.9

23"(20")

22
24
21

G

VOLTAGE DETECTOR — 10

ARITHMETIC CONTROL SECTION

EP 2 648 009 A1

# *Fig.10*

32(30)

ARITHMETIC
CONTROL SECTION

6 6a

37 7a

ARITHMETIC
CONTROL SECTION

*Fig.11*

EP 2 648 009 A1

33(30)

31

25

CURRENT
DETECTOR

AC POWER
SUPPLY

G

ARITHMETIC
CONTROL
SECTION

# Fig.12

```
                    ┌─────────┐
                    │  START  │
                    └─────────┘
                         │
   ┌─────────────────────┼────────────────────────────┐
   │                     ▼                             │
   │  ┌──────────────────────────────────────┐         │
   │  │      SELECT SOLAR CELL STRING         │──S1     │
   │  └──────────────────────────────────────┘         │
   │                     │                             │
   │  ┌──────────────────────────────────────┐         │
   │  │ PARALLEL OFF SELECTED SOLAR CELL      │──S2     │
   │  │ STRING FROM SOLAR ENERGY              │         │
   │  │ GENERATOR SYSTEM                      │         │
   │  └──────────────────────────────────────┘         │
   │                     │                             │
   │  ┌──────────────────────────────────────┐         │
   │  │ CONNECT SOLAR CELL STRING IN          │──S3     │
   │  │ PARALLELED-OFF STATE TO               │         │
   │  │ MEASUREMENT SECTION                   │         │
   │  └──────────────────────────────────────┘         │
   │                     │                             │
   │  ┌──────────────────────────────────────┐         │
   │  │ MEASURE LEAKAGE CURRENT VALUE AND     │──S31    │
   │  │ AC VOLTAGE VALUE AND WAVEFORMS        │         │
   │  │ OF THOSE VALUES                       │         │
   │  └──────────────────────────────────────┘         │
   │                     │                             │
   │  ┌──────────────────────────────────────┐         │
   │  │ CALCULATE INSULATION RESISTANCE VALUE │──S32    │
   │  └──────────────────────────────────────┘         │
   │                     │                             │
   │  ┌──────────────────────────────────────┐         │
   │  │      GROUND FAULT DETERMINATION       │──S11    │
   │  └──────────────────────────────────────┘         │
   │                     │                             │
   │                  ╱──┴──╲     S12                   │
   │               ╱─         ─╲          YES           │
   │            ╱ IS GROUND FAULT ╲──────────┐          │
   │            ╲   DETECTED?    ╱            │          │
   │               ╲─         ─╱             │          │
   │                  ╲──┬──╱                │          │
   │                     │ NO                │          │
   │  ┌──────────────────────────────────────┐          │
   │  │ CONNECT SOLAR CELL STRING IN         │──S13      │
   │  │ PARALLELED-OFF STATE                 │           │
   │  └──────────────────────────────────────┘          │
   │                     │◄───────────────────┘          │
   │                  ╱──┴──╲    S14                     │
   │       NO      ╱─        ─╲                          │
   └──────────── IS GROUND FAULT ╲                       
              ╲ DETERMINATION    ╱                       
              ╲ COMPLETED FOR   ╱                        
               ╲ ALL SOLAR CELL╱                         
                ╲  STRINGS?   ╱                          
                  ╲──┬──╱                                
                     │ YES                               
                ┌─────────┐                              
                │   END   │                              
                └─────────┘                              
```

Fig.13

EP 2 648 009 A1

*Fig.14*

33"(30")

*Fig.15*

43(40)

DC POWER SUPPLY  42

41

VOLTAGE DETECTOR  10

ARITHMETIC CONTROL SECTION

G

EP 2 648 009 A1

## Fig.16

```
                    ( START )
                        │
    ┌──────────────────►│
    │                   ▼
    │        ┌─────────────────────────────┐
    │        │  SELECT SOLAR CELL STRING   │──S1
    │        └─────────────────────────────┘
    │                   │
    │                   ▼
    │   ┌──────────────────────────────────────┐
    │   │ PARALLEL OFF SELECTED SOLAR CELL STRING FROM │──S2
    │   │  SOLAR ENERGY GENERATOR SYSTEM        │
    │   └──────────────────────────────────────┘
    │                   │
    │                   ▼
    │   ┌──────────────────────────────────────┐
    │   │ CONNECT SOLAR CELL STRING IN PARALLELED-OFF STATE │──S3
    │   │      TO MEASUREMENT SECTION           │
    │   └──────────────────────────────────────┘
    │                   │
    │                   ▼
    │   ┌──────────────────────────────────────┐
    │   │ MEASURE VOLTAGE VALUE OF SENSING RESISTOR │──S41
    │   └──────────────────────────────────────┘
    │                   │
    │                   ▼
    │   ┌──────────────────────────────────────┐
    │   │  CALCULATE LEAKAGE CURRENT VALUE      │──S42
    │   └──────────────────────────────────────┘
    │                   │
    │                   ▼
    │   ┌──────────────────────────────────────┐
    │   │    GROUND FAULT DETERMINATION         │──S11
    │   └──────────────────────────────────────┘
    │                   │
    │                   ▼
    │              ╱──────────╲  S12
    │           ╱                ╲     YES
    │        ╱ IS GROUND FAULT DETECTED? ╲──────────┐
    │           ╲                ╱                   │
    │              ╲──────────╱                      │
    │                   │ NO                         │
    │                   ▼                            │
    │   ┌──────────────────────────────────┐         │
    │   │  CONNECT SOLAR CELL STRING IN     │──S13    │
    │   │    PARALLELED-OFF STATE           │         │
    │   └──────────────────────────────────┘         │
    │                   │                            │
    │                   ▼◄───────────────────────────┘
    │              ╱──────────╲  S14
    │   NO      ╱  IS GROUND FAULT ╲
    └─────────╱ DETERMINATION COMPLETED FOR ╲
              ╲  ALL SOLAR CELL  ╱
                 ╲  STRINGS?   ╱
                    ╲──────╱
                       │ YES
                       ▼
                    ( END )
```

EP 2 648 009 A1

*Fig.17*

43'(40')

DC POWER
SUPPLY

42

CURRENT
DETECTOR

25

ARITHMETIC
CONTROL
SECTION

G

## INTERNATIONAL SEARCH REPORT

| | International application No. |
|---|---|
| | PCT/JP2011/077250 |

A.   CLASSIFICATION OF SUBJECT MATTER
*G01R31/02*(2006.01)i, *G01R31/26*(2006.01)i, *H01L31/04*(2006.01)i

According to International Patent Classification (IPC) or to both national classification and IPC

B.   FIELDS SEARCHED

Minimum documentation searched (classification system followed by classification symbols)
G01R31/02-31/06, 31/26, H01L31/04

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| Y | JP 7-325121 A  (The Tokyo Electric Power Co., Inc.), 12 December 1995 (12.12.1995), paragraphs [0014], [0020] to [0023]; fig. 1, 3 (Family: none) | 1-18 |
| Y | JP 2005-168156 A  (Mitsubishi Heavy Industries, Ltd.), 23 June 2005 (23.06.2005), paragraphs [0014], [0023] (Family: none) | 1-18 |
| Y | JP 2004-215439 A  (Sharp Corp.), 29 July 2004 (29.07.2004), paragraphs [0047] to [0050]; fig. 2 (Family: none) | 2,12 |

☒  Further documents are listed in the continuation of Box C.            ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 February, 2012 (13.02.12) | 28 February, 2012 (28.02.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

EP 2 648 009 A1

**INTERNATIONAL SEARCH REPORT**

International application No.

PCT/JP2011/077250

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 1-170860 A  (Fujitsu Ltd.), 05 July 1989 (05.07.1989), page 2, lower right column, lines 8 to 19; fig. 3 (Family: none) | 3,13 |
| Y | JP 3-179272 A  (Tempearl Industrial Co., Ltd.), 05 August 1991 (05.08.1991), page 9, upper right column, lines 6 to 13; fig. 3, 16 (Family: none) | 4 |
| Y | JP 2005-62124 A  (The Chugoku Electric Power Co., Inc.), 10 March 2005 (10.03.2005), paragraph [0022]; fig. 1 (Family: none) | 5 |
| Y | JP 54-38536 A  (The Kansai Electric Power Co., Inc.), 23 March 1979 (23.03.1979), page 2, lower left column, lines 3 to 13; fig. 5 (Family: none) | 6 |
| Y | JP 8-163704 A  (Fujikura Ltd.), 21 June 1996 (21.06.1996), paragraphs [0024] to [0026]; fig. 1 (Family: none) | 7 |

Form PCT/ISA/210 (continuation of second sheet) (July 2009)

37

**EP 2 648 009 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003158282 A